# EUROPEAN PATENT SPECIFICATION

(11) **EP 1 626 106 B1**
(45) Date of publication and mention of the grant of the patent: **11.05.2011**
(21) Application number: 05253217.3
(22) Date of filing: 25.05.2005
(51) Int. Cl.: C23C 20/04, G03F 7/20

(54) **Method of forming a conductive wiring pattern by laser irradiation**
Verfahren zur Herstellung von Leiterbahnmustern durch Laserbestrahlung
Méthode de préparation d'un dessin conducteur de cablage par irradiation de laser

(30) Priority: 23.07.2004 JP 2004215478
(43) Date of publication of application: 15.02.2006
(73) Proprietor: Sumitomo Electric Industries, Ltd., Osaka (JP)
(72) Inventor: Okada, Issei, Sumitomo Electric Industries, Ltd., Konohana-ku Osaka (JP); Shimoda, Kohei Sumitomo Electric Industries, Ltd., Konohana-ku Osaka (JP); Ebata, Keiji Sumitomo Electric Industries, Ltd., Konohana-ku Osaka (JP); Hirai,Takayuki, Sumitomo Electric Industries, Ltd., Konohana-ku Osaka (JP)
(74) Representative: Cross, Rupert Edward Blount

(56) References cited:
- EP-A- 1 345 261
- US-A1- 2003 232 286

## Description

This invention relates to a method of forming arbitrary patterned conductive circuits on boards with a metal colloid solution prepared by diffusing nano-sized metal fine particles into a solvent.

There are a screen printing method and a resist-lithography method for producing wiring patterns on epoxy boards or other material boards. The screen printing method forms wiring circuits by preparing a screen having slits at positions corresponding to the positions where wirings should be made, fitting the screen onto a board, painting the screen/board with a conductive metal paste, heating and hardening the metal paste into permanent wiring patterns. What determines the patterns of wirings are the slit patterns inscribed on the screens. What eliminates the solvent out of the metal paste is the heating process. The heating treatment evaporates the solvent, hardens the resin including in the paste and fixes the metal patterns on the board. The printing method transcribes wiring patterns onto screen slit patterns. The metal paste has electric conductivity inherently. The metal paste does not acquires electric conductivity by additional crystal growth induced by heating in the screen printing method.

The lithography method forms wiring patterns on a board by covering the overall board with a copper thin film by evaporating or sputtering, painting a resist, exposing the resist through a mask with desired patterns by a mercury lamp, removing (ashing) the resist, and eliminating extra copper by etching.

Ultrafine patterns are also formed on silicon wafers by a similar lithography method containing the steps of making an aluminum thin film on a silicon wafer, spin-coating the Al-film with a rest, setting a mask with object patterns on the wafer, exposing the resist via the mask by ultraviolet rays, etching extra aluminum away and ashing the resist. Lithography provides semiconductor wafers or insulator wafers with wiring patterns by a set of the steps including painting of a resist, exposure via a patterned mask, removal of a metal film and ashing of the resist. What determines the wiring patterns are the patterns on the mask. The resist is indispensable for transcribing the mask patterns onto the metal thin film.

Wiring patterns on printing boards have been made by a screen printing method for a long time. Wiring patterns on silicon wafers have been made by a lithography method. Use of a screen (stencil) having slits inhibits the screen printing method for making very fine wiring patterns. The lithography method can depict fine wiring patterns having small line widths. Lithography, however, requires a large-scaled, expensive apparatus. The lithography method includes expensive steps ,such as resist-painting, exposure, etching, and ashing.

Japanese Patent Laying Open No.2001-35255, "Silver particle dispersion liquid" (Document 1) proposed a metallic paste dispersing silver fine particles or silver oxide fine particles in organic solvents which are mineral spirits, tridecane, dodecylbenzene, α-terpineol and so on. Document 1 insisted that the authors produced a mineral spirit dispersion liquid which contains 20 wt% of silver fine particles of, e.g., an 8nm average diameter in mineral spirit, which shows a viscosity of 5 cP (centipoise) at room temperature. The authors of Document 1 produced another mineral spirit dispersion liquid which includes 20 wt% of palladium particles of a 6nm average diameter in mineral spirit.

Document 1 produced a pattern on a Si wafer by spin-coating the Si wafer with the silver/palladium mineral spirit dispersion liquid, heating the coated Si wafer at 250°C for two minutes in the atmosphere for evaporating an organic solvent, sintering the silver/palladium spirit at 300°C for ten minutes, forming a 1µm silver/palladium film, painting a resist on the silver/palladium film, exposing the resist via a photomask having a pattern, and eliminating unnecessary parts by development. Two steps of processing harden the silver/palladium paste. The first step is heating at 250°C for two minutes for evaporating the organic solvent. The second step is heating at 300°C for ten minutes for sintering the paste. The final product is similar to the wirings produced by aluminum evaporation. The paste film is converted to a conductived metal film. The conventional photolithography can depict patterns on the metal film.

At an early stage of semiconductor technology, wirings of LSIs(large-scaled integrated circuits) had been aluminum patterns produced by aluminum-sputtering and photolithography. Progress of miniaturization of wiring patterns reduced line widths which heightened electric current density. Extreme high current density had a tendency to induce occurrence of electromigration. Trials have been done for building copper wirings instead of the prevailing aluminum wirings. It is rare for copper to produce electromigration. But it is difficult to etch copper. Both wet etching and dry etching are inapplicable to copper. Incapability of etching excludes photolithography. Copper allows a new double-damascening method to make wirings by boring holes on an object substrate in advance, filling the holes with copper melt, solidifying the copper melt into copper solid in the holes, and erasing unnecessary copper projected out of the holes. The double-damascening method is a sophisticated, complicated and difficult method. Another candidate which has high resistance against electromigration is silver wirings. Trials of silver wirings have been done. Since silver is endowed with low resistivity, silver has been deemed to be an appropriate material for fine wirings. Uniform thick painting films are prepared by dispersing silver fine particles into an organic solvent in a uniform distribution silver solution, painting an object board with the silver solution, heating and drying the solution and making a uniform-thick silver films on the board. Then the use of photolithography can produce silver wiring patterns on the board. The silver solution is a novel material. But the following steps can be processed by the conventional photolithography which has ripened in the silicon semiconductor technology.

Japanese Patent Laying Open No.2002-324966, "Method of forming circuit patterns by ink-jet printing" proposed a method of dispersing silver fine particles of 1nm to 100nm diameters into alkyl amines, adding thermosetting resin, e.g., phenol resin, producing a conductive metallic paste including silver particles, alkyl amines and the thermosetting resin, ejecting the conductive paste as fine drops from a scanning head of an ink-jet printer on an object board, depicting patters with a jet beam, and making paste patterns made of silver on the board. The line width is about 100µm (0.1mm). The thickness is about 5µm. The paste patterns depicted by the ink-jet printer are annealed at 150°C for 30 minutes for removing a dispersion agent and further annealed at 210°C for 60 minutes for setting the thermohardening resin. The double steps of annealing are necessary to evaporate the dispersion agent and to harden the thermosetting resin (e.g., phenol resin).

The paste jetting method can directly depict wiring patterns by a scanning ink-jet printer with a metal paste instead of a printer ink. Movements of the printer head determine the patterns of wirings, which is similar to conventional printers. The paste jetting is a printing method which dispenses with screens (stencils). Resist painting, via-mask exposure and etching are unnecessary. The document (Japanese Patent Laying Open No.2002-324966) asserted that the conductivity of the wiring patterns made by the paste jetting was 2.8×10⁻⁵ Ωcm.

The paste jetting method, however, has a drawback that two steps of long-term annealing are indispensable for eliminating the dispersion agent and hardening the thermosetting resin. A dot of the paste jet has a diameter of 16µm to 20µm. The dot size inhibits the paste jet method from depicting fine patterns having narrow line widths. The method cannot be applied to produce wirings having line widths narrower than 100µm(0.1mm).

Japanese Patent Laying Open No.2003-156839, "Materials for mother patterns and a printing method by the mother pattern" does not relate to wirings but relates to a technique of making mother patterns which are negative origin patterns of transcription. A mother pattern is made by painting a metallic colloid on a sustainer board, irradiating selected parts of the metallic colloid with a scanning laser beam for revealing metal parts, and making desired metal-revealed parts. Unirradiated parts are left to be metallic colloid. Unirradiated metallic colloid is still hydrophilic. Irradiated metal-exposed parts are oilphilic. A printing ink adheres selectively to oilphilic parts. When the printing ink is supplied to the mother pattern, laser-irradiated oilphilic parts maintain the ink but unirradiated hydrophilic parts recoil the ink. The laser-irradiated oilphilic parts of the mother pattern are transcribed onto sheets of paper. The prior document (Japanese Patent Laying Open No.2003-156839), which does not relate to the production of wirings, is here cited, because the method makes use of laser irradiation.

Conventional screen printing methods have a drawback of preparing slit-carrying stencils for painting metal pastes therethrough. Another drawback is the restriction of line widths. It is impossible to make narrow-width wiring patterns, because the widths are restricted by the widths of slits.

The lithography method comprising the steps of resist-painting, photolithography, etching and ashing is a sophisticated technology ripened in silicon semiconductor industries. The lithography method requires photomasks, resists and a large-scaled exposure apparatus for exposing masked resists.

The exposure apparatus demands a large sum of equipment investment from device makers. Use of resists requires an ashing apparatus for eliminating the resists after etching. Unselected metal parts still adhere to boards. Water-washing cannot remove the unselected metal parts from the board. Dry-etching or wet-etching is indispensable for removing unselected metal parts. The etching apparatus is also large-scaled and expensive, which raises the cost. Etching gases or etching agents, which are poisonous and harmful, have a tendency to induce environmental pollution.

A method which is immune from the abovedescribed defects is required to form various fine wiring patterns on a board with a high degree of freedom at low cost. This invention aims at proposing such a low cost wiring patterning method.

To achieve the foregoing objects and in accordance with the purpose of the invention, embodiments will be broadly described herein.

The present invention is a wiring method of preparing metal dispersion colloid by suspending metal fine particles by a dispersion agent in a solvent, painting an object board with the metal dispersion colloid, drying the metal dispersion colloid into a thin metal suspension film by removing the solvent, irradiating selected parts of the thin metal suspension film with scanning or diffracted laser beams, growing metal fine particles into large metal grains on the laser-irradiated parts, enhancing the cohesion of the large grown metal grains to the board and inducing conductivity to the large grown metal grains, washing unselected fine particles away from the board and forming conductive wirings of desired patterns on the board.

The wirings formed on the board by the present invention include metal particles with diameters of 30nm (0.03µm) to 10000nm(10µm). Porosity is 0.01% to 10%.

Here, the metal, which forms conductive wirings, should have high resistance against oxidization and high electric conductivity. Noble metals are suitable. The best candidate is silver. The next best candidate is gold. Other noble metals are also available. Silver (Ag), gold (Au), ruthenium (Ru), rhodium (Rh), palladium (Pd), osmium (Os), iridium (Ir), platinum (Pt), copper (Cu), nickel (Ni) and their alloys are appropriate metals for forming metal dispersion colloid. Alkali metals (Na, K, Li, Rb, Cs, etc.) or alkaline-earth metals (Ba, Ca, Sr, etc.) are less suitable. It is difficult to keep fine particles of alkali or alkaline-earth metals suspended in any solution since they have a strong tendency of oxidization. Aluminum (Al) is inappropriate. Fine aluminum particles are dangerous owing to rapid oxidization. Gallium (Ga) and indium (In) are also cunsuitable by the same reason as aluminum. Iron (Fe) is improper to a metal suspension due to fast oxidization and low electric conductivity.

Here, the fine particle means a particle with a diameter from 0.5 nm to 200nm. Since the diameters are subnanometer or nanometers, the fine particles are sometimes called "nanoparticles" in the present description. Nanoparticles are endowed with high activities owing to large ratios (S/V) of surface areas (S) to volumes (V). A preferable range of diameters of nanoparticles is from 1nm to 30nm.

The word "solvent" is here used for a special meaning slightly different from the conventional usage. Conventional solvent solves an object material (solute) and fully extinguishes solid parts of the object solute. The solvent, however, means a fluid liquid which allows fine solid particles to be suspended with inherent sizes and shapes therein. The solvent neither reacts with nor ionizes the nanoparticles. No chemical reaction takes place between the solvent and the nanoparticles. Appropriate solvents are water (H₂0) or alcohols. The solvent in the present description denotes a liquid which includes metal nanoparticles and has fluidity sufficient to paint surfaces of object boards.

If an alcohol were employed as a solvent at early stages, reduction would be induced by a high reduction tendency of alcohols. Thus the first proper solvent should be water(pure-water). After the colloid has been reduced, large metal particles have appeared and obstacle anions have been removed, alcohols can be added to the solution as an additional solvent.

The dispersion agent is an organic material for preventing metal fine particles from aggregating in a liquid and maintaining metal fine particles floating in the liquid. Metal fine particles have a high surface activity and have a tendency to aggregate for reducing the surface activity. If metal fine particles were supplied into water or alcohol, particles would aggregate together into large grains and would lose floatage and fluidity. Spin-coating of the particles/water or particles/alcohol cannot form uniform thin films on boards due to irregular aggregation. The dispersion agent which prevents metal fine particles from cohering is indispensable for making metal colloids.

The chemicals, which work as a dispersion agent, are polycarboxylic acid type macromolecular anions or chemicals having a molecular weight more than 150 and having strong adhesion to metal fine particles. For example, the dispersion agents are dodecyl amine (Molecular weight: Mw=185), stearyl amine (Mw=270), oleil amine (Mw=267), stearic acid amide (Mw=287), Oleic acid amide (Mw=281), myristic acid (Mw=228), lauric acid (Mw=200), palmitic acid (Mw=256) and so on. Dispersion agent molecules encapsulate each one of metal fine particles. Dispersion agents prohibit fine particles from cohering together. Fine particles are isolated from each other in a solvent by the enclosing dispersion agents. The metal fine particles maintain the separated state. Cohesion of metal particles is hindered by the dispersion agent. Preferable dispersion agents are chemicals which excel in thermal-decomposition property. Appropriate dispersion agents should have a critical temperature lower than 450°C at which the weight goes down to 80 % in heat weight analysis at a heating rate of 10°C/min under the atmosphere. It is much better that dispersion agents have a critical temperature less than 400°C for inducing a weight loss of 20% in the same heat wight analysis.

Polycarboxylic acid type macromolecular anions sold on the market are, e.g., EFKA5071 (produced by EFKA Chemical Corporation), Flowlen G-700 (produced by Kyoeishakagaku Corporation), Flowlen TG-750W (produced by Kyoeishakagaku Corporation), Flowlen G-700DMEA (produced by Kyoeishakagaku Corporation), Softanol (produced by Nipponshokubai Corporation), Selna D735 (produced by Chukyoyushi Corporation) and Discoat N-14 (Daiichikogyoseiyaku Corporation).

The metal dispersion colloids are suspension liquids having water (or alcohol) and metal fine particles suspended in water. The metal dispersion colloids can be stored for a long term in glass bottles or plastics bottles without precipitation and degradation.

Object boards are painted with metal dispersion colloids. The object boards are glass boards, ceramic boards, epoxy boards, polyimide boards, polyethylene terephthalate (PET) boards, silicon (Si) wafers, gallium arsenide (GaAs) wafers, indium phosphide (InP) wafers, silicon dioxide wafers (SiO₂) and so on.

If a step of heating objects up to a high temperature were included in a method, the method could not be applied to plastics or low-melting point glass. This invention succeeds in keeping the object boards unheated by converging the laser beam only on the metal colloid. This invention is applicable to plastic boards and low-melting point glass boards. The scope of applicable object boards is enlarged due to the exclusion of heating steps. This is one of the features of the present invention.

This invention includes neither wet etching nor dry etching. Rigidity, refractoriness, sturdiness and resistance against chemicals are not required of object boards. The metal dispersion colloid is dried. Object boards should pass in the drying process. The drying temperature is about 100 °C. The drying time is ten minutes to twenty minutes. Most plastics boards are acceptable. If a candidate board degenerates even at 100°C, the present invention can be applied by lowering the drying temperature down to 80°C. The present invention is available for almost all boards of plastics, woods, glass, metals, ceramics and crystals. This is a great advantage of the present invention.

The metal dispersion colloid can be painted on boards by a brush, a spinner and so forth. Painting techniques of the metal dispersion colloid on object boards are spin-coating, doctor blade coating, rolling coating, spray coating, dipping coating, screen printing and ink-jet printing and so on.

The boards painted with the dispersion colloid are dried for eliminating the solvent and depriving the colloid of fluidity. Room temperature drying or hot window-blowing drying is available. Drying eliminates only the solvent (water or alcohol) without chemical reaction. Dried metal suspension films have no electric conductivity. Metal nanoparticles are separated by dispersion agent molecules from other nanoparticles. The dispersion agent is an inherent insulator. Thus no current flows in the dried metal suspension film. The metal suspension film has poor adhesion to the board. If the film were washed by water, the metal suspension film would easily be eliminated from the surface of the board.

Then the metal suspension film is partially irradiated with a strong laser beam or beams. The power of the laser beam evaporates or solves dispersing agent molecules. Since the separation of the dispersion agent molecules is removed, metal fine particles come in direct contact with each other. Localized sintering is induced by the laser power. The sintering facilitates the fine particles to aggregate and grow to be larger metal grains. The Inventors confirmed by electron microscope observation that the fine particles cohere to bigger granules on the parts irradiated by the laser beam. Growth into large metal grains rapidly reduce electric resistance. Electric conductivity is given to the suspension film of the laser-irradiated parts.

Enlarged grains by the growth are endowed with tight cohesion to the board on the irradiated parts. The irradiated parts of the film permanently adhere to the board. Water cannot wash the irradiated parts away. The irradiation of laser beams gives both board-coherence and electric conduction to the metal suspension film. However, the bestowal of coherence and conduction requires large power of laser beams. As explained later, Embodiments employ a laser beam of 450mW power. The 450mW laser beam can be obtained by gathering power of hundreds of current InGaN lasers.

Laser light evaporates dispersion agent molecules. Vacancies are made among metal particles. The laser beam induces metal particles to aggregate for filling vacancies and to grow to be larger grains. The laser beam bestows growing grains the coherence to the underlying board. Both the dispersion agent molecules and the metal fine particles absorb the laser light. Big metal grains do not absorb but reflect away visible light. Fine particles of metal induce random- and multi-reflection of laser light. Many times of reflection enable the fine particles to absorb laser power with high efficiency. The metal dispersion colloids of the present invention look black. High absorption rate gives darkness to the metal dispersion colloids.

It is supposed that photons included in laser beams would cut the chemical bonds between metal fine particles and dispersion agent molecules. The dispersion agent molecules are freed from the metal fine particles. Laser power heats, evaporates, solves and removes the dispersion agent molecules. Extinction of the dispersion agent molecules would be caused by evaporation or dissolution. Loose chemical bonds between the dispersion agent molecules and the metal nanoparticles should be cut before the extinction. Decoupling of the chemical bonds requires high power density of the laser beams. Even if a high power density laser were obtained, laser irradiation being not absorbed by the metal dispersion colloids would be unoperative yet. Thus absorption spectra of the metal dispersion colloid and the dispersion agent are measured.

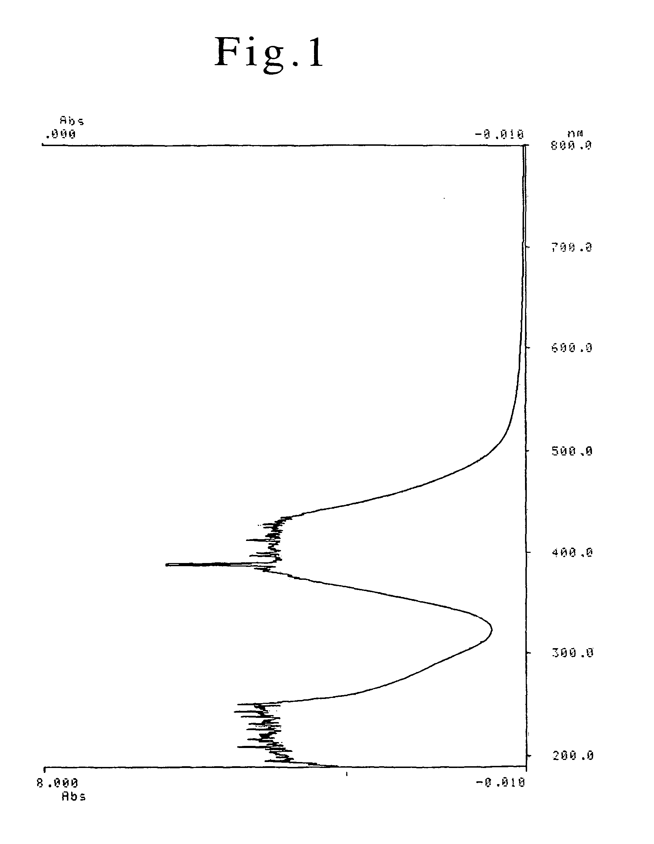

Fig.1 is an absorption spectrum of a silver dispersion colloid. The abscissa is wavelengths (nm) of input light. The ordinate is absorption coefficients (arbitrary unit) of the silver ink (dispersion colloid). A large absorption peak appears in ultraviolet/violet/greenblue regions between 300nm and 550 nm. A range between 350nm and 490nm, in particular, shows large absorption. Another large absorption peak exists between 200 nm and 240 nm in the ultraviolet region.

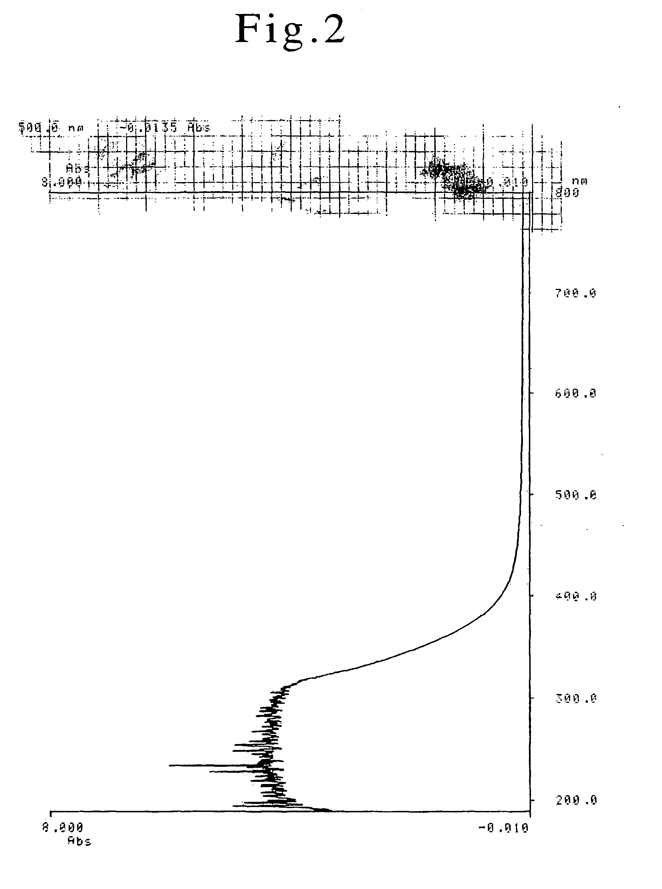

Fig.2 is an absorption spectrum of a dispersion agent. The spectrum has a large absorption peak between 200nm and 300nm. In comparison with Fig.2, the absorption peak between 200nm and 240nm appearing in Fig.1 should derive from the dispersion agent. Another absorption peak between 350nm and 490 nm in Fig. 1 should originate from the absorption by silver fine particles. Selection of a wavelength enables us to irradiate either of dispersion agent molecules or metal fine particles with light exclusively.

Which should be irradiated, dispersion agent molecules or metal fine particles? This is a problem. The Inventors of the present invention thought that it would be effective to irradiate metal fine particles with light for promoting the cohesion of metal fine particles and the crystal growth of metal. The Inventors had an idea for making use of a laser which emits a wavelength ranging between 350nm and 490nm as a light source. 350nm to 490nm wavelengths correspond to ultraviolet/violet/blue rays. The dispersion agent cannot absorb ultraviolet/violet/blue rays. Instead, metal particles absorb the light of the wavelength range (350nm-490nm),and raise the temperature. An effective wavelength range of lasers turns out to be 300nm to 550nm in general in the present invention. Enhancement of the temperature evaporates or decomposes the dispersion agent molecules. Extinction of the dispersion agent allows metal particles to cohere into large grains and to stick to the base board. Once the metal grains have glued to the board, washing cannot erase the metal grains away from the board.

The Inventors hit on a good idea of making the best use of InₓGa₁₋ₓN (abbr. InGaN) type LEDs or LDs as a light source for emitting light of a wavelength between 350nm and 490nm. The Inventors chose 408nm wavelength InGaN semiconductor lasers as a light source. InGaN lasers can make light of an arbitrary wavelength from 350nm to 490 nm by varying the mixture crystal ratio x in InₓGa₁₋ₓN. Embodiments described later will adopt 408nm wavelength laser diodes. The total power is 450mW in Embodiments.

No single laser diode can make such big power of 450mW. The Inventors produced a large power source by preparing N InGaN laser diodes (N is a large number) and an N: 1 fiber coupler, coupling N laser diodes (LDs) with N ends of the fiber coupler, introducing LD beams into the N:1 fiber coupler, and gathering all beams emanating from the LDs into a single fiber. For example, an assembly of a hundred of high power laser diodes of 4.5mW produces a strong light source of 450mW. Another set of two hundreds of laser diodes of 2.25mW will give another large power light source of 450mW.

In practice, the LD assembly incurs loss of power at junctions. The real sum of power of the LD assembly is smaller than the nominal sum. An arbitrary number of LDs can be joined by optical fibers in the same direction. A strong light source having arbitrary desired power can be built by unifying a large number of identical laser diodes by the fiber coupler. Tiny laser diodes are congenial to slender optical fibers. A hundred laser diodes, two hundred laser diodes or so can easily be unified by optical fiber couplers.

The present invention forms a desired wiring pattern on a board by painting a surface of the board with a metal dispersion colloid including metal nanoparticles, drying the metal dispersion colloid into a thin metal suspension film, irradiating the metal suspension film by a laser beam capable of depicting a desired pattern, hardening the irradiated parts of the suspension film, washing unirradiated parts away, and maintaining a wiring pattern of the laser-irradiated parts on the board.

The metal suspension film which has been painted and dried lies ephemerally on the board. Only laser-irradiated parts cohere to the board. Unirradiated, unnecessary parts are easily eliminated by washing, for example, supersonic washing. This invention dispenses with etching. Scanning of a laser beam enables the present invention to depict an arbitrary wiring pattern on a board. The laser beam scanning which excels in high degree of freedom of design, is suitable for making unroutine wiring patterns. Otherwise, diffractive optical elements (DOEs) allow the present invention to form a desired complicated wiring pattern without scanning of laser beams.

Irradiation of laser beams brings about conductivity and coherency to the suspension film. Annealing following the irradiation is entirely unnecessary. Elimination of post-annealing is one of the features of the present invention. Shortening of a focal depth of a beam guiding optical system enables thin suspension films to absorb all the laser power, and inhibits laser power from arriving at boards. The boards are left unheated in the case. This invention is applicable to plastic boards or low-melting glass boards which have poor resistance against heat. A wide scope of applicable boards is another feature of the present invention.

A prior technique of making wiring patterns is a screen printing method. The present invention is superior in fineness of wiring patterns to the screen printing method which paints a screen(stencil)-covering board with a metallic paste with a painting roller. The minimum width wiring patterns is equal to the diameter of a laser beam. Converging a laser beam narrower allows the present invention to form a wiring pattern having narrower widths. The present invention can eliminate the cost of fabricating the screens (stencils) which have many slits patterned after an object wiring.

Another prior technique of depicting wiring patterns is a lithography method including resist-painting, photolithography, etching and ashing, which is prevalent in semiconductor wirings. In comparison with the lithography method, the ink/irradiation method of the present invention has advantages of elimination of photomasks, resists, exposure of resists, etching and ashing of resists. The ink/irradiation method can do without a large, expensive exposure apparatus which produces strong-power rays of short wavelengths for exposing resists. The lithography method requires etching processes for removing unnecessary parts. The ink/irradiation method (this invention) can remove unnecessary parts only by washing with water. The present invention dispenses with poisonous etching gases, etching liquids and an expensive etching apparatus. The present invention can eliminate the ashing process of removing resists. What depicts wiring patterns is a laser optical system. The steps of making wirings on boards are simplified by the ink/irradiation method. Current design rules on silicon wafers are 130nm or 65nm. The present invention does not aim at such an ultrafine wiring pattern. Object patterns of the present invention have line widths ranging from micrometers to hundreds of micrometers.

Object wirings of the ink/irradiation method have widths far broader than the current design rule. The minimum of the wiring widths is determined by the diameter of a laser beam on the board. In the case of guiding a laser beam by an optical fiber, a fiber core size and a reduction rate of an optical system determine the size of the laser beam on the board. A multimode fiber with a wide core inhibits the laser beam from writing narrow width wirings even at a small reduction rate.

Adoption of a single-mode fiber of a 10µm diameter core and a reduction rate of 1/20 enables the laser beam to depict fine patterns having a 0.5µm width. When the width of object wirings is so narrow, the property of the metal wirings depends upon the size of metal fine particles. Ultrafine particles having diameters of 0.5nm to 10nm should be chosen. But writing submicron wirings is not a main purpose of the present invention. The main purpose is to make wirings having widths wider than 1µm and narrower than 1mm.

Examples of the invention will be described with reference to the several figures of the accompanying drawings in which:
Fig. 1 is a graph showing a result of measuring absorption spectrum of a silver suspension as an embodiment of the present invention. The abscissa is wavelengths (nm) of light. The ordinate is absorption coefficients (arbitrary unit). A first absorption peak lies between 200nm and 250 nm. A second absorption peak appears between 350 nm and 490 nm.
Fig. 2 is a graph showing a result of measuring absorption spectrum of another silver suspension as another embodiment of the present invention. The abscissa is wavelengths (nm) of light. The ordinate is absorption coefficients (arbitrary unit). A absorption peak lies between 200 nm and 300 nm.

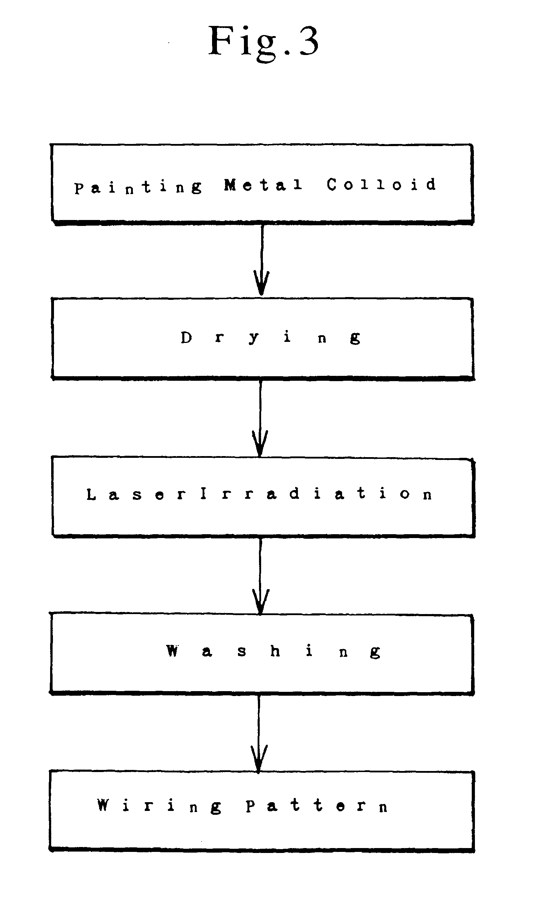

Fig.3 is a process diagram clarifying the steps of producing wiring patterns of the present invention. The diagram shows the steps of painting a metal suspension on a board, drying the metal suspension, irradiating the metal suspension with a laser beam, washing the board and making a wiring pattern on the board.

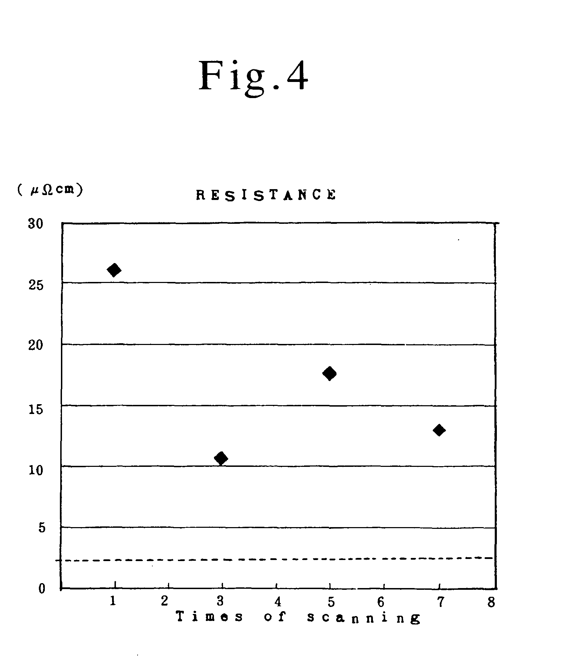

Fig.4 is a graph showing a relation between laser beam scanning times and electrical resistivity (µΩcm) in an experiment of painting an object board with sliver dispersion colloid (suspension), drying the suspension into a thin film, irradiating and scanning the film with a beam of a 408nm wavelength and 450mW power, measuring electrical resistance of metal patterns formed on the board and repeating several times of laser irradiating scans and resistance measurements. The abscissa is times of laser irradiating scans. The ordinate is electric resistivity (µΩcm) measured.

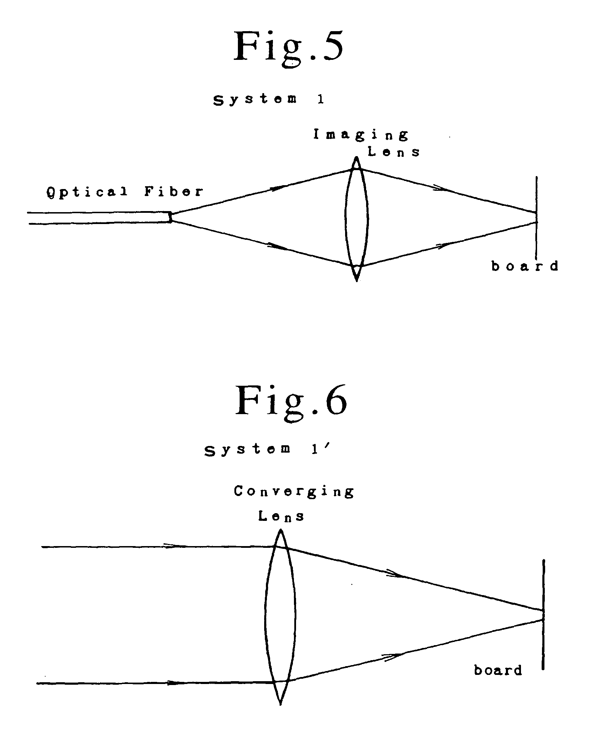

Fig.5 is a side view of an optical system for converging a diverging laser beam emitted out of an optical fiber by an imaging mask/lens assembly, irradiating an object board coated with metal suspension and making irradiated patterns on the board.
Fig.6 is a side view of another optical system for converging a wide parallel laser beam by a converging lens, irradiating a metal-suspension coated board with the converged beam and making a light spot on the board.

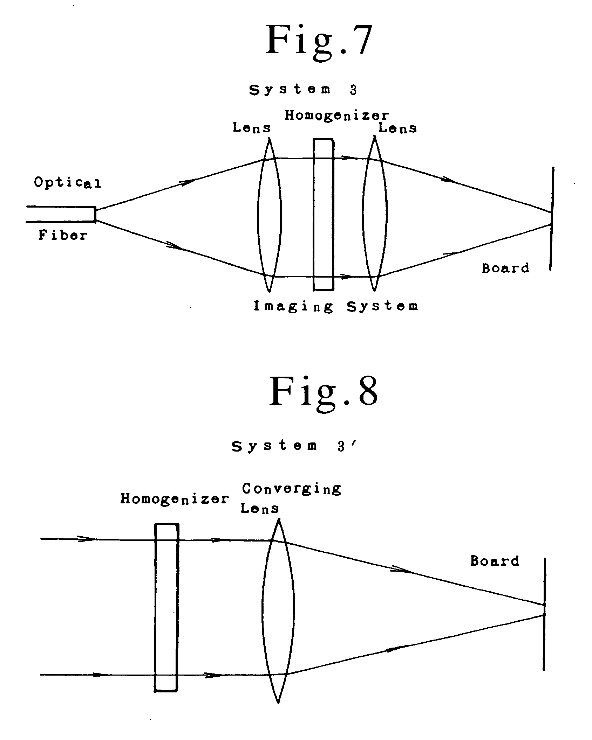

Fig.7 is a side view of another optical system for converging a diverging laser beam emitted out of an optical fiber by a lens/homogenizer/lens assembly, irradiating a metal-suspension coated board with the converged beam and making a uniform power distribution (tophat) light spot on the board.
Fig.8 is a side view of another optical system for converging a wide parallel laser beam by a homogenizer/lens assembly, irradiating a metal-suspension coated board with the converged beam and making a uniform power distribution (tophat) light spot on the board.

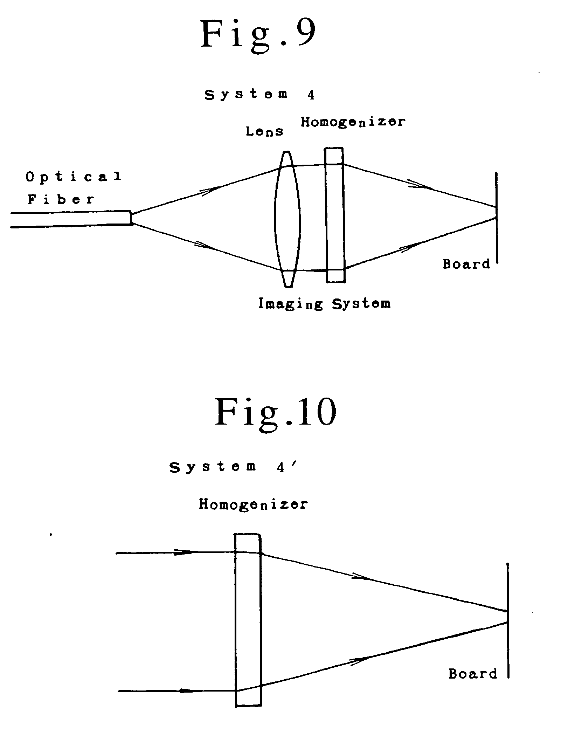

Fig.9 is a side view of a further optical system for converging a diverging laser beam emitted out of an optical fiber by a lens/homogenizer assembly, irradiating a metal-suspension coated board with the converged beam and making a uniform power distribution (tophat) light spot on the board.
Fig.10 is a side view of a further optical system for converging a wide parallel laser beam by a homogenizer with a lens function, irradiating a metal-suspension coated board with the converged beam and making a uniform power distribution (tophat) light spot on the board.

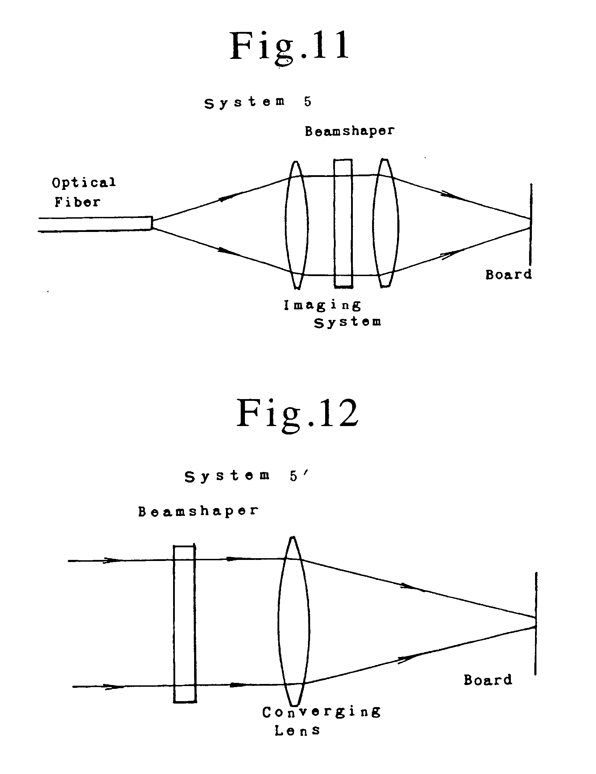

Fig.11 is a side view of another optical system for converging a diverging laser beam emitted out of an optical fiber by a lens/shaper/lens assembly, irradiating a metal-suspension coated board with the converged beam and making an arbitrary, desired power distribution light spot on the board.
Fig.12 is a side view of a further optical system for converging a wide parallel laser beam by a shaper/lens assembly, irradiating a metal-suspension coated board with the converged beam and making an arbitrary power distribution light spot on the board.

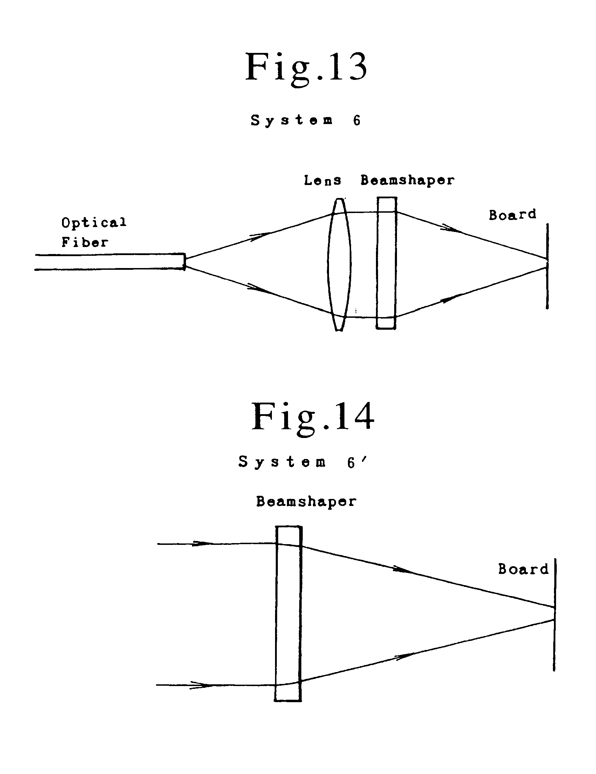

Fig.13 is a side view of another optical system for converging a diverging laser beam emitted out of an optical fiber by a lens/shaper assembly, irradiating a metal-suspension coated board with the converged beam and making an arbitrary, desired power distribution light spot on the board.
Fig.14 is a side view of a further optical system for converging a wide parallel laser beam by a beamshaper with a lens function, irradiating a metal-suspension coated board with the converged beam and making an arbitrary power distribution light spot on the board.

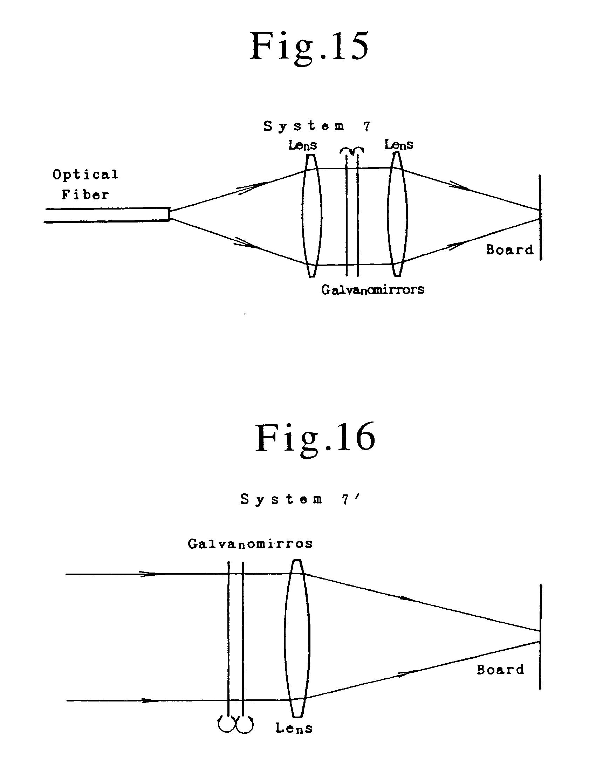

Fig.15 is a side view of another optical system for converging a diverging laser beam emitted out of an optical fiber by a lens/galvanomirrors/lens assembly, swaying the galvanomirrors, scanning the laser beam in x- and y-directions, irradiating a metal-suspension coated board with the converged beam and making a light spot oscillating in x- and y-directions on the board.
Fig.16 is a side view of another optical system for converging a wide parallel laser beam by a galvanomirrors/lens assembly, scanning the laser beam by swaying the galvanomirrors in x- and y-directions, irradiating a metal-suspension coated board with the converged beam and depicting an arbitrary pattern on the board.

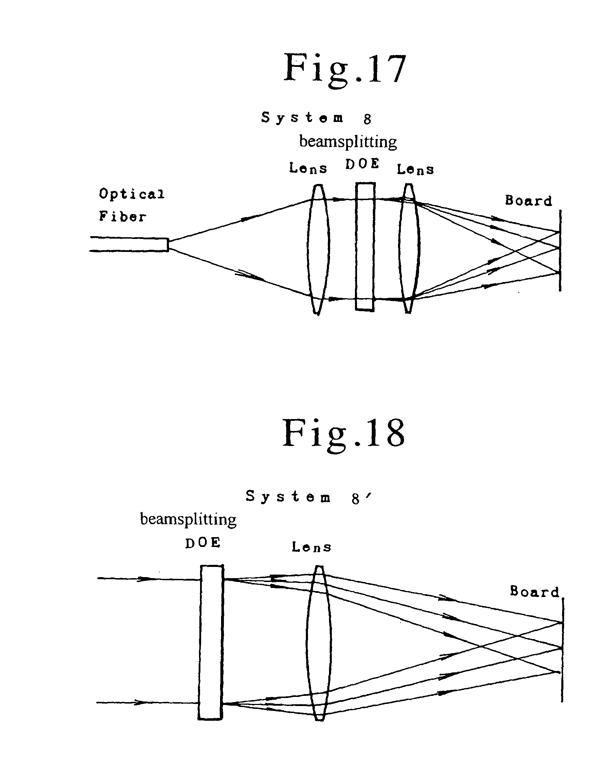

Fig.17 is a side view of another optical system for converging a diverging laser beam emitted from an optical fiber by a lens/beamsplitting-DOE/lens assembly, dividing the laser beam into a plurality of beams, irradiating a metal-suspension coated board with a set of beams and making several light spots on the board.
Fig.18 is a side view of another optical system for converging a wide parallel laser beam by a beamsplitting-DOE/lens assembly, dividing the laser beam into a plurality of beams, irradiating a metal-suspension coated board with a set of beams and making several light spots on the board.

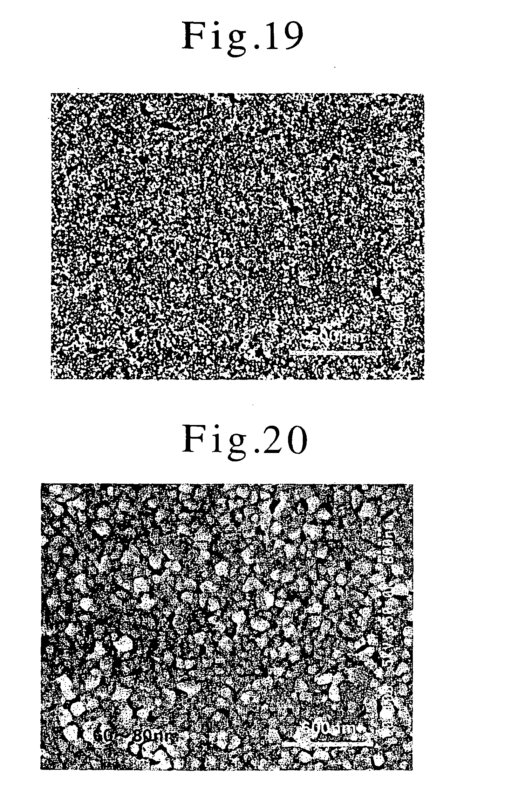

Fig.19 is an electron microscope photograph of a film prepared by painting a board with silver dispersion colloid and drying the dispersion colloid into a film. A definite straight line drawn at a right bottom of the photograph corresponds to a 600 nm length . Silver polycrystalline grains are small.
Fig.20 is an electron microscope photograph of a film produced by painting a board with silver dispersion colloid, drying the dispersion colloid into a film, irradiating the film with a laser beam of a 408 nm wavelength and 450mW power. A definite straight line depicted at a right bottom of the photograph corresponds to a 600 nm length . Silver polycrystalline grains grow larger than those before irradiation.

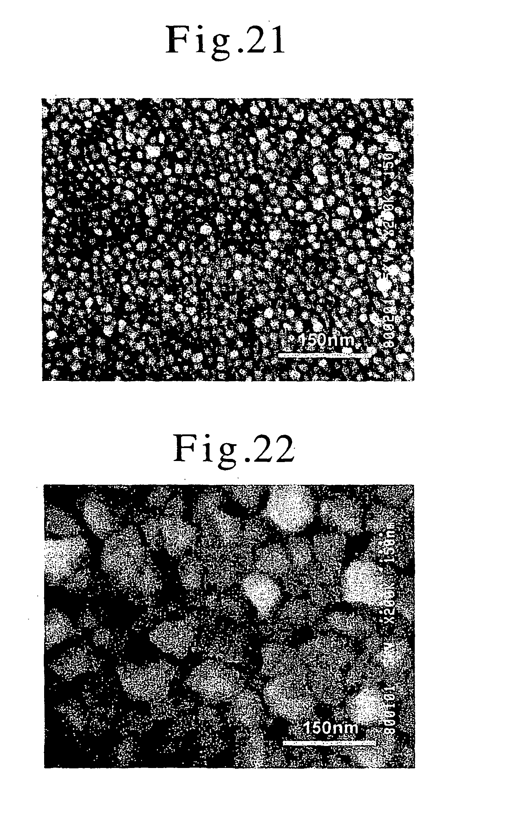

Fig.21 is a (Fig.19) four times enlarged electron microscope photograph of a film prepared by painting a board with silver dispersion colloid and drying the dispersion colloid into a film. A definite straight line drawn at a right bottom of the photograph corresponds to a 150 nm length . Silver polycrystalline grains are small. Silver grain sizes are 7nm to 25nm. The average silver grain size is about 12 nm.
Fig.22 is a (Fig.20) four times enlarged electron microscope photograph of a film produced by painting a board with silver dispersion colloid, drying the dispersion colloid into a film, and irradiating the film with a laser beam of a 408 nm wavelength and 450mW power. A definite straight line depicted at a right bottom of the photograph corresponds to a 150 nm length . Silver polycrystalline grains grow larger than those before irradiation. Small grains have 30 nm diameters. Larger grains have 100nm diameters. Average silver grains have 40nm to 70nm in diameters. Laser irradiation enlarges silver polycrystalline grains.

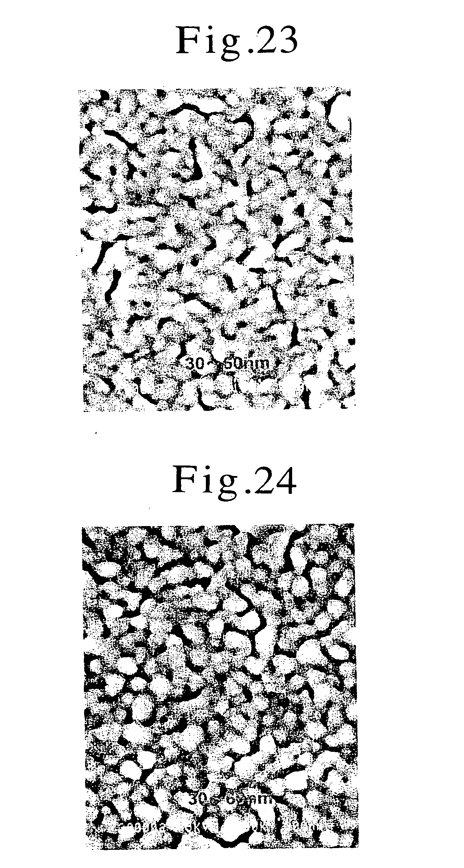

Fig.23 is an electron microscope photograph of a metal suspension film prepared by painting a board with silver dispersion colloid, drying the dispersion colloid into a metal suspension film, and irradiating the metal suspension film with one shot pulse of a laser beam of a 408 nm wavelength and 450mW power. The one-shot irradiated metal suspension film has an electric resistivity of 26µΩcm.
Fig.24 is an electron microscope photograph of a metal suspension film prepared by painting a board with silver dispersion colloid, drying the dispersion colloid into a metal suspension film, and irradiating the metal suspension film with three shot pulses of a laser beam of a 408nm wavelength and 450mW power. The three-shot irradiated metal suspension film has an electric resistivity of 11µΩcm.

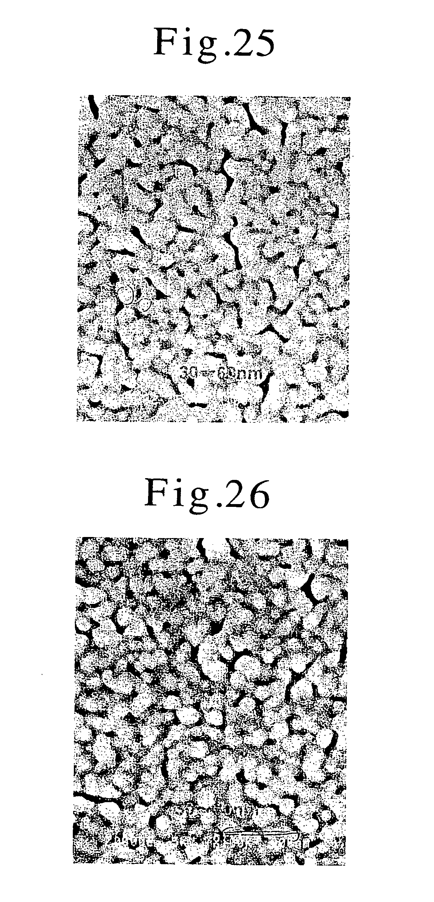

Fig.25 is an electron microscope photograph of a metal suspension film prepared by painting a board with silver dispersion colloid, drying the dispersion colloid into a metal suspension film, and irradiating the metal suspension film with five shot pulses of a laser beam of a 408nm wavelength and 450mW power. The five-shot irradiated metal suspension film has an electric resistivity of 18µΩcm.
Fig.26 is an electron microscope photograph of a metal suspension film prepared by painting a board with silver dispersion colloid, drying the dispersion colloid into a metal suspension film, and irradiating the metal suspension film with seven-shot pulses of a laser beam of a 408nm wavelength and 450mW power. The electric resistivity of the seven-shot irradiated metal suspension film falls to 13µΩcm.

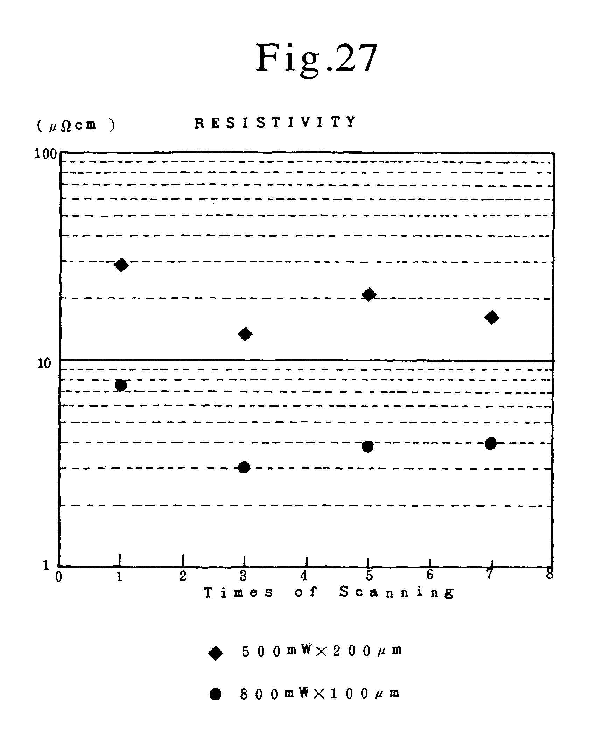

Fig. 27 is a graph showing a relation between irradiation scanning times and electric resistivity of metal suspension films prepared by painting a board with silver dispersion colloid, drying the colloid into a metal-suspension film, and irradiating the metal-suspension film a plurality of times with different sizes and different power of a 408nm wavelength. Black lozenges denote a result of measurements of electric resistivity of the suspension films irradiated by a 200µmΦ laser beam of 500mW power. Black rounds denote another result of measurements of electric resistivity of the suspension films irradiated by a 100µmΦ laser beam of 800mW power. The abscissa is scanning times of the laser beam. The ordinate is electric resistivity (µΩcm).

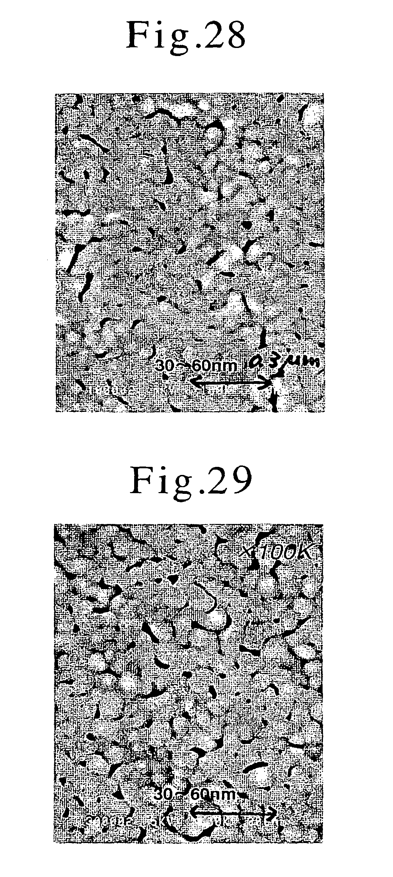

Fig.28 is a 100k (100000;k=1000) times magnified electron microscope photograph of a one-shot film (resistivity: 26µΩcm) prepared by painting a board with silver dispersion colloid, drying the dispersion colloid into a metal-suspension film, and irradiating the film with one shot of a laser beam of a 408 nm wavelength and 450mW power.
Fig.29 is a 100k (100000) times magnified electron microscope photograph of a three-shot film (resistivity: 13.3µΩcm) prepared by painting a board with silver dispersion colloid, drying the dispersion colloid into a metal-suspension film, and irradiating the film with three shots of a laser beam of a 408 nm wavelength and 450mW power.

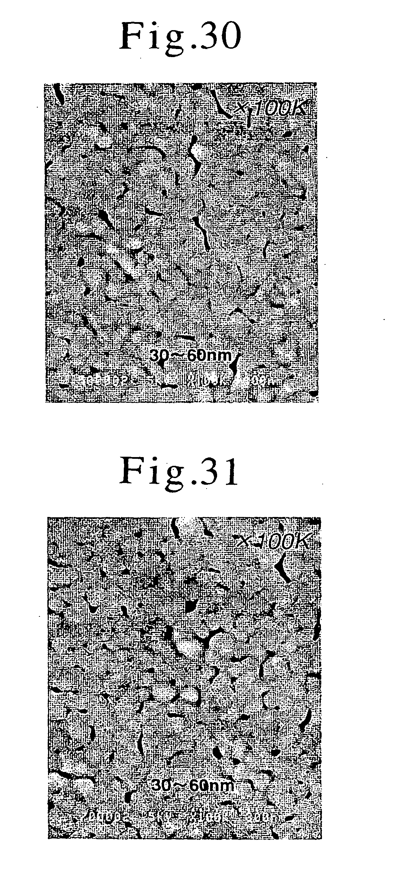

Fig.30 is a 100k (100000) times magnified electron microscope photograph of a five-shot film (resistivity: 20.8µΩcm) prepared by painting a board with silver dispersion colloid, drying the dispersion colloid into a metal-suspension film, irradiating the film with five-shots of a laser beam of a 408 nm wavelength and 450mW power.
Fig.31 is a 100k (100000) times magnified electron microscope photograph of a seven-shot film (resistivity: 16.2µΩcm) prepared by painting a board with silver dispersion colloid, drying the dispersion colloid into a metal-suspension film, and irradiating the film with seven-shots of a laser beam of a 408 nm wavelength and 450mW power.

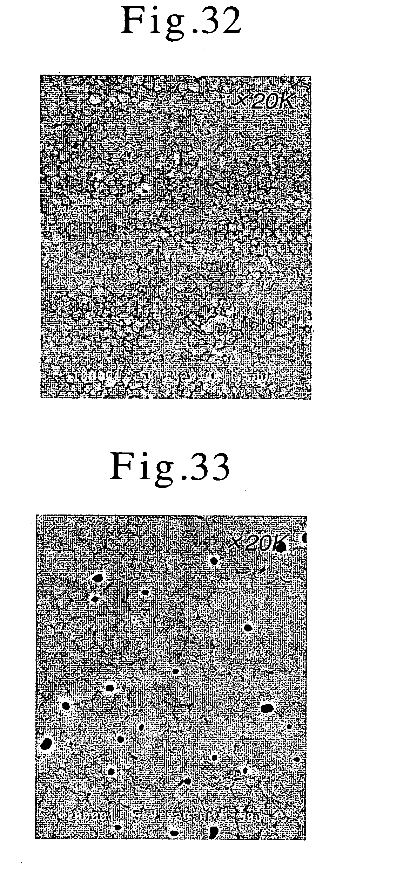

Fig.32 is a 20k (20000) times magnified electron microscope photograph of a one-shot film (resistivity: 7.5µΩcm) prepared by painting a board with silver dispersion colloid, drying the dispersion colloid into a metal-suspension film, and irradiating the film with one-shot of a 100µmΦ laser beam of a 408 nm wavelength and 800mW power.
Fig.33 is a 20k (20000) times magnified electron microscope photograph of a three-shot film (resistivity: 3.0µΩcm) prepared by painting a board with silver dispersion colloid, drying the dispersion colloid into a metal-suspension film, irradiating the film with three-shots of a 100µmΦ laser beam of a 408 nm wavelength and 800mW power.

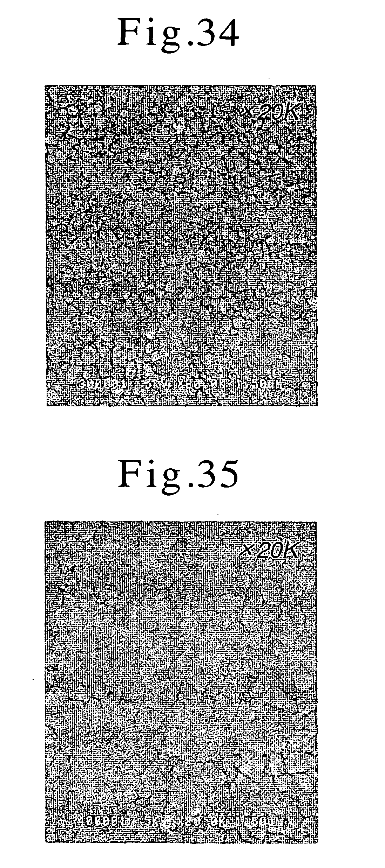

Fig.34 is a 20k (20000) times magnified electron microscope photograph of a five-shot film (resistivity: 3.8µΩcm) prepared by painting a board with silver dispersion colloid, drying the dispersion colloid into a metal-suspension film, irradiating the film with five shots of a 100µmΦ laser beam of a 408 nm wavelength and 800mW power.
Fig.35 is a 20k (20000) times magnified electron microscope photograph of a seven-shot film (resistivity: 4.0µΩcm) prepared by painting a board with silver dispersion colloid, drying the dispersion colloid into a metal-suspension film, and irradiating the film with seven-shots of a 100µmΦ laser beam of a 408 nm wavelength and 800mW power.

Fourteen sorts of metal dispersion colloid including metal nanoparticles are described. Materials are listed first in each explanation. Water is a solvent. Metal is supplied to water by a metallic acid including metallic ions. Mixing of the materials makes a solution containing metallic ions as cations in the acids. Metallic cations are fully dissolved in water. A cation is not electrically-neutral but positively-charged. No powder exists in the solution. In advance, a dispersion agent is added to the solution for preventing metal powder from cohering together. Then a reducing agent is supplied to the solution. The solution is stirred. The reducing agent is an agent for reducing metallic cations into metal powder which is electrically neutral. Reduction means giving a unit negative charge. Oxidization, which is an antonym of reduction, means giving a unit positive charge. Metallic cations are reduced to metallic fine powder in the solution. Metallic powder contains nanoparticles of metal. Appearance of metal neutral nanoparticles gives a color inherent to the metal to the solution. After the reduction of metallic cations into nanoparticles, anions of the acid still remain in the solution. The anions are obstacles. The anions should be eliminated by electrodialysis or centrifugal separation. At the final stage, surface tension and viscosity are adjusted by adding water, organic solvents and coupling agents. The final product is a liquid including metal nanoparticles, dispersion agent molecules and a solvent (water in many cases). Each of the metal nanoparticles is encapsulated by dispersion agent molecules. Nanoparticles have high inherent surface activity for cohering together. Dispersion agent molecules separate nanoparticles by encapsulating. Enclosure by the dispersion molecules hinders nanoparticles from cohering. Nanoparticles accompanied by the dispersion agent molecules are floating in the solvent. Such a liquid is called a colloid or a metal dispersion colloid in the description.

### [Metal dispersion colloid 1 (silver dispersion colloid)]

**Starting Materials;**

| | |
|---|---|
| Water (H₂O) | 500g, |
| silver nitrate (AgNO₃) | 25.4g, |
| ammonia gas(NH₃) →ammonia silver nitrate solution, Selna D-735 | 16 g |
| (Trademark; Chukyoyushi Corporation: polycarboxylic acid type macromolecular anion) ethylene glycol (OHCH₂CH₂OH; reducing agent) | 2.5g |
| Mixing: | about 10 minutes |

| | |
|---|---|
| Electrodialysis (Eliminating nitrate ions) | |
| Additions; Organic solvent, water and silane-coupling agent (for adjusting surface tension and viscosity) | |

### [Metal dispersion colloid 2 (silver dispersion colloid)]

**Starting Materials;**

| | |
|---|---|
| Water (H₂O) | 500g, |
| chloroauric acid (HAuCl₄ · 4H₂O) | 41.2g, |
| Flowlene G-700 DMEA | 8 g |
| (Kyoeishakagaku Corporation: polycarboxylic acid type macromolecular anion) ethanol (CH₃CH₂OH; reducing agent) | 10.6g |
| Mixing: | about 10 minutes |

| | |
|---|---|
| Electrodialysis (Eliminating chloride ions) | |
| Additions; Organic solvent, water and silane-coupling agent (for adjusting surface tension and viscosity) | |

### [Metal dispersion colloid 3 (silver dispersion colloid)]

**Starting Materials;**

| | |
|---|---|
| Water (H₂O) | 500g, |
| silver chloride (AgCl) | 85.8g, |
| ammonia gas(NH₃) →ammonia silver chloride solution, Discoat N-14 | 48 g |
| (Daiichikogyoseiyaku Corporation: polycarboxylic acid type macromolecular anion titanium trichloride (TiCl₃; reducing agent) | 16g |
| Mixing: | about 5 minutes |

| | |
|---|---|
| Electrodialysis (Eliminating chloride ions) | |
| Additions; Organic solvent, water and silane-coupling agent (for adjusting surface tension and viscosity) | |

### [Metal dispersion colloid 4 (silver dispersion colloid)]

**Starting Materials;**

| | |
|---|---|
| Water (H₂O) | 500g, |
| silver nitrate (AgNO₃) | 25.4g, |
| ammonia gas(NH₃) →ammonia silver nitrate solution, EFKA5071 | 12 g |
| (Trademark; EFKA chemical Corporation: polycarboxylic acid type macromolecular anion) hydrazine (NH₂NH₂; reducing agent) | 14.4g |
| Mixing: | about 10 minutes |

| | |
|---|---|
| Electrodialysis (Eliminating chloride ions) | |
| Additions; Organic solvent, water and silane-coupling agent (for adjusting surface tension and viscosity) | |

### [Metal dispersion colloid 5 (platinum dispersion colloid)]

**Starting Materials;**

| | |
|---|---|
| Water (H₂O) | 500g, |
| chloroplatinic acid (H₂PtCl₄) | 77.7g, |
| Selna D-735 | 4g |
| (Chukyoyushi Corporation: polycarboxylic acid type macromolecular anion) 2-propanol (CH₃CH(OH)CH₃; reducing agent) | 9.3g |
| Mixing: | about 40 minutes |

| | |
|---|---|
| Electrodialysis (Eliminating chloride ions) | |
| Additions; Organic solvent, water and silane-coupling agent (for adjusting surface tension and viscosity) | |

### [Metal dispersion colloid 6 (palladium dispersion colloid)]

**Starting Materials;**

| | |
|---|---|
| Water (H₂O) | 500g, |
| palladium chloride (PdCl₂) | 21.3g, |
| EFKA5071 | 12 g |
| (Trademark; EFKA Chemical Corporation: polycarboxylic acid type macromolecular anion) ethanol (CH₃CH₂OH; reducing agent) | 13.8g |
| Mixing: | about 80 minutes |
| Electrodialysis (Eliminating chloride ions) | |
| Additions; Organic solvent, water and silane-coupling agent (for adjusting surface tension and viscosity) | |

### [Metal dispersion colloid 7 (silver dispersion colloid)]

**Starting Materials;**

| | |
|---|---|
| Water (H₂O) | 500g, |
| silver nitrate (AgNO₃) | 170g, |
| ammonia gas(NH₃) →ammonia silver nitrate solution, Flowlen G 700DMEA | 48g |
| (Trademark; Kyoeishakagaku Corporation: polycarboxylic acid type macromolecular anion) sodium citrate (C₃H₄(OH)(COONa)₃; reducing agent) | 15.5g |
| Mixing: | about 50 minutes |

| | |
|---|---|
| Electrodialysis (Eliminating nitrate ions) | |
| Additions; Organic solvent, water and silane-coupling agent (for adjusting surface tension and viscosity) | |

### [Metal dispersion colloid 8 (gold dispersion colloid)]

**Starting Materials;**

| | |
|---|---|
| Water (H₂O) | 500g, |
| chloroauric acid (HAuCl₄·4H₂O) | 185g, |
| Flowlen G 700 | 6g |
| (Trademark; Kyoeishakagaku Corporation: polycarboxylic acid type macromolecular anion) 2-propanol (CH₃CH(OH)CH₃; reducing agent) | 40.8g |
| Mixing: | about 40 minutes |

| | |
|---|---|
| Electrodialysis (Eliminating chloride ions) | |
| Additions; Organic solvent, water and silane-coupling agent (for adjusting surface tension and viscosity) | |

### [Metal dispersion colloid 9 (platinum dispersion colloid)]

**Starting Materials;**

| | |
|---|---|
| Water (H₂O) | 500g, |
| chloroplatinic acid (H₂PtCl₄) | 51.8g, |
| Flowlen G 700 | 4g |
| (Trademark; Kyoeishakagaku Corporation: polycarboxylic acid type macromolecular anion) sodium borohydride (NaBH₄; reducing agent) | 17.1g |
| Mixing: | about 5 minutes |
| Electrodialysis (Eliminating chloride ions) | |
| Additions; Organic solvent, water and silane-coupling agent (for adjusting surface tension and viscosity) | |

### [Metal dispersion colloid 10 (ruthenium dispersion colloid)]

**Starting Materials;**

| | |
|---|---|
| Water (H₂O) | 500g, |
| ruthenium chloride (RuCl₃) | 6.9g, |
| Selna D-735 | 8g |
| (Trademark; Chukyoyushi Corporation: polycarboxylic acid type macromolecular anion) ethanol (CH₃CH₂OH; reducing agent) | 6.9g |
| Mixing: | about 80minutes |

| | |
|---|---|
| Electrodialysis (Eliminating chloride ions) | |
| Additions; Organic solvent, water and silane-coupling agent (for adjusting surface tension and viscosity) | |

### [Metal dispersion colloid 11 (silver dispersion colloid)]

**Starting Materials;**

| | |
|---|---|
| Water (H₂O) | 500g, |
| silver nitrate (AgNO₃) | 2.5g, |
| ammonia water (NH₃+H₂O; pH=10.8) oleic acid amide | 3g |
| ethylene glycol (OHCH₂CH₂OH; reducing agent) | 90g |
| Mixing: | about 30 minutes |

| | |
|---|---|
| Ultrafiltration (Eliminating nitrate ions) | |
| Additions; surface-active agent, water and silane-coupling agent (for adjusting surface tension and viscosity) | |

### [Metal dispersion colloid 12 (silver dispersion colloid)]

**Starting Materials;**

| | |
|---|---|
| Water (H₂O) | 500g, |
| silver nitrate (AgNO₃) | 25.4g, |
| ammonia water (NH₃+H₂O; pH=10.8) ethanol myristic acid | 20g |
| glucose (C₆H₁₂O₆; reducing agent) | 54g |
| Mixing: | about 10 minutes |
| Ultrafiltration (Eliminating nitrate ions) | |
| Additions; surface-active agent, water and silane-coupling agent (for adjusting surface tension and viscosity) | |

### [Metal dispersion colloid 13 (palladium dispersion colloid)]

**Starting Materials;**

| | |
|---|---|
| Water (H₂O) | 500g, |
| palladium nitrate (PdNO₃) | 10.5g, |
| ammonia water (NH₃+H₂O; pH=9.0) acetopalmitic acid | 25g |
| ascorbic acid (C₆H₈O₆; reducing agent) | 17.6g |
| Mixing: | about 1 minute |

| | |
|---|---|
| Centrifugal separation (Eliminating nitrate ions) | |
| Additions; organic solvent, water and silane-coupling agent (for adjusting surface tension and viscosity) | |

### [Metal dispersion colloid 14 (silver/palladium alloy dispersion colloid)]

**Starting Materials;**

| | |
|---|---|
| Water (H₂O) | 500g, |
| argentum(silver) nitrate (AgNO₃) | 12.7g |
| palladium nitrate (PdNO₃) | 5.3g, |
| ammonia water (NH₃+H₂O; pH=11) Flowlen G-700DMEA | 8g |
| (Kyoeishakagaku Corporation; polycarboxylic acid type macromolecular anions) citric acid (C₃H₄(OH)(COOH)₃; reducing agent) | 19g |
| Mixing | about 40 minutes |

| | |
|---|---|
| Electrodialysis (Eliminating nitrate ions) | |
| Additions; organic solvent water and silane-coupling agent (for adjusting surface tension and viscosity) | |

As clearly explained above, metal dispersion colloid is prepared by adding a reducing agent to an acid solution containing metallic ions and reducing metallic ions into metal fine grains suspended in a colloid. An important matter is an early supply of a dispersion agent at a starting step into the acid solution. If a dispersion agent were supplied into the acid solution after adding a reducing agent, aggregation would start and would prevent metallic ions from forming ultrafine metal nanoparticles. Anions composing the acid remain in the solution containing the nanoparticles. The anions are unnecessary. The anions are eliminated by electrodialysis, centrifugal separation or margin filtering. If once of electrodialysis etc. cannot eliminate all the anions, once more, twice more times of electrodialysis should be repeated till the whole of the anions have been removed.

The light wavelengths which enable metal dispersion colloid to harden and metal nanoparticles to aggregate together should be 300nm to 550nm, which has already been described. More favorable wavelengths are 350nm to 490nm.

InGaN semiconductor lasers can produce light having a wavelength in the above range. But an InGaN laser is too weak to induce the chemical reaction in the metal colloids. A light source of large power can be obtained by coupling many InGaN lasers by optical fibers to be a single source. A set of several tens or hundreds of InGaN lasers can be a strong light source enough to induce the desired reaction in metal suspensions. The wavelength of InGaN lasers can be varied in the preferable range between 350nm and 490 nm by changing the mixture ratio of In and Ga. The above Embodiments adopt 408nm InGaN lasers (λ= 408nm).

There are many laser irradiating optical systems suitable for exposing the metal suspension films.

### [Laser beam irradiating optical systems]

### [System (1) (Fig.5)]

### Optical fiber + imaging lens + suspension-coated board

A laser beam is introduced into an optical fiber. The optical system converges a diverging laser beam emitted from the optical fiber into a light spot on the suspension-coated board. Power distribution of the laser beam is transferred to the power distribution of the light spot by the optical system. As shown in Fig.5, an optical fiber, an imaging lens and a suspension-coated board align along a straight line. A laser beam is once guided into the optical fiber. The beam propagates in the fiber and goes out of the other end of the fiber. The lens converges the beam and makes an image spot on the suspension-carrying board.

### [System (2) (Fig.6)]

### Wide parallel beam + converging lens + suspension-carrying board

A laser beam is expanded into a wide parallel beam by collimator lenses. The wide parallel beam is converged into a small light spot on the suspension-carrying board by a converging lens.

### [System (3) (Fig.7)]

### Optical fiber + lens + homogenizer + lens + suspension-carrying board

System (3) is built by adding a diffraction type or refraction type homogenizer and a lens between the lens and the board of System (1) of Fig. 5. In Fig.7, the diverging beam emitted from an optical fiber is converged and converted into a tophat beam on the suspension-carrying board by the homogenizer and the lens.

### [System (3') (Fig.8)]

### Wide parallel beam + homogenizer + lens + suspension-carrying board

System (3') is built by adding a diffraction type or refraction type homogenizer befored the lens to System (2) of Fig. 6.

In Fig.8, a wide parallel beam is converted into a uniform power beam by the homogenizer. The uniform power beam is converged to a uniform power spot on the suspension-carrying board by the lens. Homogenizers convert a gaussian power distribution beam into a uniform power (tophat) distribution beam. One homogenizer is a set of aspherical lenses. The aspherical lenses change power distribution and restore coherent phases by refraction. Another homogenizer is a diffraction optical element (DOE) which changes the beam power distribution by diffraction.

### [System (4) (Fig.9)]

### Optical fiber + lens + homogenizer + suspension-carrying board

System (4) is built by endowing a homogenizer DOE with a converging function and eliminating the rear lens from System (3) of Fig.7. The homogenizer DOE is a Fresnel DOE. In Fig.9, the diverging beam emitted from the optical fiber is converged by a lens and converted into a converging tophat beam on the suspension-carrying board by the fresnel-type homogenizer (DOE) and the lens.

### [System (4') (Fig.10)]

### Wide parallel beam + homogenizer + suspension-carrying board

System (4') is built by providing a homogenizer with a converging (Fresnel) function and eliminating the lens from System (3') of Fig. 8. In Fig.10, a wide laser beam is converted by the Fresnel-type homogenizer (DOE) into a converging tophat beam on the board .

### [System (5) (Fig. 11)]

### Optical fiber + lens + beamshaper + lens + suspension-carrying board

System (5) contains a refractive or diffractive beamshaper which can convert an input beam into an arbitrary pattern-distribution beam on the suspension-carrying board. The beamshaper can be composed of aspherical lenses or a diffractive optical element (DOE). In Fig.11, a set of a former lens and a latter lens build a collimator for making a wide parallel beam. The diverging beam emitted from an optical fiber is converted into a wide parallel beam by a lens, converted by the beamshaper into an arbitrary pattern beam, and converged by another lens on the suspension-carrying board.

### [System (5') (Fig.12)]

### Wide parallel beam + beamshaper + lens + suspension-carrying board

System (5') contains a refractive or diffractive beamshaper converting an input beam into an arbitrary pattern-distribution beam. In Fig.12, a wide parallel beam is converted by the beamshaper into an arbitrary pattern beam, and converged by a lens on the suspension-carrying board.

### [System (6) (Fig.13)]

### Optical fiber + lens+ beamshaper + suspension-carrying board

System (6) contains a Fresnel-type refractive or diffractive beamshaper which can convert an input beam into a converging arbitrary pattern-distribution beam. The "Fresnel-type" means the possession of the converging function. The Fresnel beamshaper can be composed of aspherical lenses or a diffractive optical element (DOE). In Fig.13, a diverging beam emitted from an optical fiber is converted into a wide parallel beam by a lens and converted by the Fresnel beamshaper into a converging arbitrary pattern beam on the suspension-carrying board.

### [System (6') (Fig.14)]

### Wide parallel beam + beamshaper + suspension-carrying board

System (6') contains a Fresnel-type refractive or diffractive beamshaper converting an input beam into a reducing arbitrary pattern-distribution beam. In Fig.14, a wide parallel beam is converted by the beamshaper into an arbitrary pattern beam and converged on the suspension-carrying board by the Fresnel beamshaper.

### [System (7) (Fig.15)]

### Optical fiber + lens + galvanomirrors + lens + suspension-carrying board

System (7) contains a set of galvanomirrors which reciprocally sway in x- and y-directions for scanning an input beam in two-dimensional space. The galvanomirrors can produce scanning continual linear patterns in x- and y-directions on the board from a continual laser beam. The galvanomirrors can produce series of intermittent dots in x- and y-directions on the board from a pulse laser beam. Use of an fθ lens enables constant angular velocity galvanomirrors to depict equi-spaced distribution of dots.

### [System (7') (Fig.16)]

### Wide parallel beam + galvanomirrors + lens + suspension-carrying board

System (7') contains a set of galvanomirrors swaying in x- and y-directions. The galvanomirrors can produce scanning continual linear patterns in x- and y-directions on the board in the case of a continual laser. The galvanomirrors can produce series of intermittent dots in x- and y-directions on the board in the case of a pulse laser.

### [System (8) (Fig.17)]

### Optical fiber + lens+ beamsplitting DOE + lens + suspension-carrying board

System (8) contains a beamsplitting DOE which has a function of dividing a single beam into a plurality of beams. System (8) inserts the beamsplitting DOE in a wide parallel beam for making a plurality of beams and depicting plural dots on the suspension-carrying board. Use of the beamsplitting DOE is profitable in the case of irradiating many points with laser beams simultaneously. In Fig.17, a beam emitted out of a fiber is converted into a parallel beam by a lens, divided into a plurality of beams by the beamsplitting DOE and converted by another lens into plural dots on the board.

### [System (8') (Fig.18)]

### Wide parallel beam + beamsplitting DOE + lens + suspension-carrying board

System (8') contains a beamsplitting DOE which has a function of dividing a single beam into a plurality of beams. In Fig.18, a wide parallel beam is divided into a plurality of beams by the beamsplitting DOE and converted by a lens into plural dots on the suspension-carrying board.

### [EMBODIMENT 1]

Polyimide boards, polyethylene terephthalate (PET) boards, glass boards, and ceramic boards are prepared as base boards. The specimen boards are spin-coated with the silver suspension ink as described in the metal suspension colloid 1.

### (Spin-coating)

A specimen board is vacuum-locked on a disc rotor of a spinner. Metal suspension colloid is dropped on the specimen. The rotor is rotated for thirty seconds at a speed of 200 rpm to 3000 rpm for making a thin suspension colloid film on the specimen board.

### (Drying)

The specimen is dried at 100 °C for 10 minutes. Water (solvent) is fully removed from the metal suspension film. The disperse agent still remains in the metal suspension film. The suspension film has a thickness of about 0.3 µm. The electric resistance is high. The specimen films are insulators. The colloid film is unstable. Washing with water can fully eliminate the suspension film from the specimen board.

### (Laser irradiation)

The optical system shown in Fig.5 is adopted as a laser irradiation apparatus. The light source is an assembly of InGaN lasers which gathers light beams of many InGaN lasers by optical fibers combined to an N: 1 coupler into a unified beam propagating in a single end of the coupler. The optical system placed in front of the unified fiber end converges the laser beam on the suspension film on the board.

| | |
|---|---|
| Light Source: | blue light LD(InGaN)s wavelength 408nm |
| Light Power: | 450 mW |
| Fiber Core: | about 400µmϕ |
| Magnifying rate: | -1/2 |
| Spot diameter on board: | about 200µmϕ |
| Scanning length: | 13 mm |

The experiment is explained in detail. Object boards are polyimide boards. 0.3µm thick silver suspension films are made on the polyimide boards by painting the polyimide boards with silver dispersion colloid and drying the dispersion colloid into a suspension film. Linear parts of the suspension film are scanned several times by an irradiating beam of a laser of a 408nm wavelength and 450mW power for evaporating the dispersion agent. The scanned part has a 13mm length and a 0.18mm width. Silver nanoparticles are aggregated and reinforced in the scanned linear parts. The suspension film is washed for eliminating unexposed silver nanoparticles. Irradiated silver suspension lines remains on the board. Resistances are measured between two ends of the silver suspension lines of different scanning times. Electric resistivities are calculated by multiplying the resistances by the thickness and the width and dividing by the length.

Surfaces of metal dispersion colloid on the boards are observed step by step by an electron microscope.

Fig. 19 is an electron microscope photograph of a silver-suspension film which is prepared by painting a polyimide board with silver dispersion colloid, and drying the colloid into a silver-suspension film. The definite line drawn at right bottom denotes a 600 nm length. White dots are silver grains. Silver grains are quite fine nanoparticles having diameters of several nanometers to tens of nanometers.

Fig.20 is an electron microscope photograph of a laser irradiated part of a silver-suspension film which is prepared by painting a polyimide board with silver dispersion colloid, drying the colloid into a silver-suspension film and irradiating the silver suspension film with a laser beam of a 408 nm wavelength and 450mW. The definite line drawn at right bottom denotes a 600 nm length. Silver grains grow larger than the grains before laser irradiation. Silver fine particles aggregate into larger grains. Large grains of nearly 100 nm diameters are seen in the photograph of Fig.20. Insufficient magnifying ratio prohibits Figs.19 and 20 from demonstrating detailed aspects of the suspensions. Then the surfaces of the suspensions before and after the laser irradiation are observed in detail by raising the magnifying ratio up to four times as high as in Figs. 19 and 20.

Fig.21 is an electron microscope photograph which is obtained by enlarging Fig.19 four times. Fig 21 demonstrates the dried silver-suspension film before laser irradiation. The definite straight line drawn at right bottom denotes a 150 nm length. Pre-irradiating silver particles have 7nm to 25nm diameters. An average diameter of the silver particles is about 12nm. Pre-irradiating silver particles are fine nanoparticles.

Fig.22 is an electron microscope photograph which is obtained by enlarging Fig.20 four times. Fig 22 demonstrates the laser-irradiated silver-suspension film. The right bottom definite straight line denotes a 150 nm length. Post-irradiating silver particles have diameters from 30 nm to 100 nm. The average diameter is about 40 nm to 70nm. Post-irradiating silver particles grow larger by aggregating together. Laser irradiation promotes the crystal growth of silver.

Fig.23 shows an electron microscope photograph of a metal suspension film (26µΩcm) prepared by painting a board with silver dispersion colloid, drying the dispersion colloid into a metal suspension film, irradiating the metal suspension film with one shot pulse of a laser beam of a 408 nm wavelength and 450 mW power. The one-shot irradiated metal suspension film has an electric resistivity of 26µΩcm. Dispersion agents are evaporated. Vacancies are produced at the positions from which the dispersion agents have escaped.

Fig.24 shows an electron microscope photograph of a metal suspension film (11µΩcm) produced by painting a board with silver dispersion colloid, drying the dispersion colloid into a metal suspension film, irradiating the metal suspension film with three shot pulses of a laser beam of a 408 nm wavelength and 450 mW power. Vacancies further increase more than those in Fig. 23.

Fig.25 shows an electron microscope photograph of a metal suspension film (18µΩcm) produced by painting a board with silver dispersion colloid, drying the dispersion colloid into a metal suspension film, irradiating the metal suspension film with five shot pulses of a laser beam of a 408 nm wavelength and 450 mW power. Silver polycrystalline grains aggregate together and grow larger. Vacancies begin to decrease.

Fig.26 shows an electron microscope photograph of a metal suspension film (13µΩcm) produced by painting a board with silver dispersion colloid, drying the dispersion colloid into a metal suspension film, irradiating the metal suspension film with seven shot pulses of a laser beam of a 408 nm wavelength and 450 mW power. Silver polycrystalline grains further grow larger by aggregation.

Electric resistances are measured between both ends of the 13mm long sliver-suspension stripe after one shot, three shots, five shots and seven shots of scanning laser beams. The measured resistances are reduced into electric resistivities by multiplying the resistance by the width and thickness and by dividing by the length of the silver stripe. The result of the measurements are listed in Table 1.

**Table 1: Irradiation scanning times, resistance, resistivity of lines irradiated**

| IRRADIATION TIMES | LENGTH (mm) | WIDTH (mm) | THICKNESS (µm) | RESISTANCE (Ω) | RESISTIVITY (µ Ω cm) |
|---|---|---|---|---|---|
| 1 | 13 | 0.18 | 0.3 | 62.8 | 26.1 |
| 2 | 13 | 0.16 | 0.3 | 28.9 | 10.7 |
| 3 | 13 | 0.17 | 0.3 | 45 | 17.7 |
| 4 | 13 | 0.16 | 0.3 | 35 | 12.9 |

Table 1 shows a result of measurements. The leftest first column denotes the laser beam irradiating (scanning) times. The second column shows lengths (mm) of laser beam scanning loci on the board. The third column denotes widths (µm) of the laser beam scanning loci. A 180µm width of wiring stripes seems to be quite wide for wiring patterns. Such a far wide metal stripe is suitable for measuring resistivity of the metal pattern exactly. Reduction of the magnification rate of the optical system narrows wiring pattern widths.

Narrower patterns enable fewer times of laser scanning or weaker laser power to aggregate metal nanoparticles into larger polycrystal grains and to reduce resistivity.

The diameter of the scanning laser beam spot determines the minimum of the depictable wiring widths. The beam spot size depends upon the laser optical system for converging the laser beam into a light spot on the object board. The size of a laser beam just emitted from an optical fiber is equal to the diameter of the core of the optical fiber. Reduction ratio of the optical system determines the ratio of the spot size to a core size of an fiber. When the core of an optical fiber is 400µm in diameter and the reduction ratio is 1/2, the minimum wiring width can be 200µm. When the reduction rate is 1/10, the minimum wiring width can be 40µm. When the core of an optical fiber is 10µm and the reduction rate is 1/10, the minimum wiring width can be 1 µm.

The fourth column means thicknesses of metal wiring patterns made on the board. The fifth column is electric resistance (Ω) of the metal wiring patterns. An increment of laser scan times reduces resistances of metal film lines. The sixth column is electric resistivities (µΩcm) of the wiring patterns. Electric resistivity is calculated by dividing the measured resistance by the length and multiplying by the section (thickness×width) of the pattern.

Fig.4 denotes the result of measurement of the resistance of silver wiring patterns after several times of laser irradiation. The abscissa denotes scanning times of laser beam irradiation. The ordinate is electric resistivity (µΩcm). The bottom line horizontally drawn at 1.59µΩcm denotes inherent electric resistivity of polycrystalline silver (Ag). Resistivities of wiring patterns are all higher than the inherent silver polycrystal resistivity. An increase of laser beam scanning times reduces the resistivity of the patterns. Ten times to fifteen times of laser scanning lower the pattern resistivity down near to the silver crystal inherent resistivity (1.59µΩcm).

**TABLE 2: Laser power 500mW, beam diameter 200 µm**

| IRRADIATION TIMES | LENGTH (mm) | WIDTH (mm) | THICKNESS (µm) | RESISTANCE (Ω) | RESISTIVITY (µ Ω cm) |
|---|---|---|---|---|---|
| 1 | 13 | 0.2 | 0.3 | 62.8 | 29.0 |
| 3 | 13 | 0.2 | 0.3 | 28.9 | 13.3 |
| 5 | 13 | 0.2 | 0.3 | 45 | 20.8 |
| 7 | 13 | 0.2 | 0.3 | 35 | 16.2 |

**TABLE 3: Laser power 800mW, beam diameter 100µm**

| IRRADIATION TIMES | LENGTH (mm) | WIDTH (mm) | THICKNESS (µm) | RESISTANCE (Ω) | RESISTIVITY (µ Ω cm) |
|---|---|---|---|---|---|
| 1 | 13 | 0.1 | 0.3 | 32.5 | 7.5 |
| 3 | 13 | 0.1 | 0.3 | 13.1 | 3.0 |
| 5 | 13 | 0.1 | 0.3 | 16.6 | 3.8 |
| 7 | 13 | 0.1 | 0.3 | 17.2 | 4.0 |

## Claims

1. A method of forming a conductive wiring pattern by laser irradiation comprising the steps of:
preparing metal dispersion colloid having metal nanoparticles having diameters of 0.5nm to 200nm, a dispersion agent and a solvent;
painting a board with the metal dispersion colloid;
drying the metal dispersion colloid on the board into a thin metal suspension film;
depicting a wiring pattern on the metal suspension film with irradiating laser beams having a wavelength between 300nm and 550nm by an optical system, thereby giving electric conductivity and cohesion to the board to the metal nanoparticles on laser-irradiated parts having the wiring pattern;
washing the board for eliminating the other parts of the film which have not been irradiated; and
producing a conductive wiring pattern same as a pattern of the parts irradiated by the laser beams.

2. The method as claimed in claim 1, wherein the dispersion agent is an organic material which has a molecular weight more than 150 and adhesion to metal fine particles

3. The method as claimed in claim 1 or claim 2, wherein the dispersion agent is polycarboxylic acid type macromolecular anions.

4. The method as claimed in claim 1, wherein the metal nanoparticles are particles of silver(Ag), gold(Au), ruthenium(Ru), rhodium(Rh), palladium(Pd), Osmium(Os), iridium(Ir), platinum (Pt), copper (Cu), nickel(Ni) or alloys of silver(Ag), gold (Au), ruthenium (Ru), rhodiwn(Rh), palladium (Pd), Osmium(Os), iridium(Tr), platinum (Pt), copper (Cu) or nickel(Ni).

5. The method as claimed in any one of claim 1 to claim 4, wherein the board is a glass board, a ceramic board, an epoxy board, a polyimide board, a polyethylene terephthalate (PET) board, a silicon (Si) wafer, a gallium arsenide (GaAs) wafer, indium phosphide (InP) wafer or a silicon dioxide (SiO₂) wafer.

6. The method as claimed in any one of claim 1 to claim 5, wherein a plurality of InGaN lasers are unified by a fiber coupler into a unified light source, and the metal suspension film on the board is irradiated by the unified beam emitted from a fiber end of the coupler.

7. The method as claimed in any one of claim 1 to claim 5, wherein the the optical system consists of a optical fiber for guiding the laser beam and an imaging system which depicts the wiring pattern by the laser beam on the board.

8. The method as claimed in any one of claim 1 to claim 5, wherein the optical system consists of an optical device for preparing a parallel laser beam and an imaging system which depicts the wiring pattern by the laser beam on the board.

9. The method as claimed in claim 7, wherein the optical system has an optical fiber guiding the laser beam and an imaging system which includes a homogenizer for producing a uniform power distribution beam on the board.

10. The method as claimed in claim 8, wherein the optical system consists of an optical device for preparing a parallel laser beam and an imaging system including a homogenizer for producing a uniform power distribution beam on the board.

11. The method as claimed in claim 7, wherein the optical system consists of an optical fiber for guiding the laser beam and an imaging system including a beamshaper for producing an arbitrary power distribution beam on the board.

12. The method as claimed in claim 8, wherein the optical system consists of an optical device for preparing a parallel laser beam and an imaging system including a beamshaper for producing an arbitrary power distribution beam on the board.

13. The method as claimed in claim 7, wherein the optical system consists of an optical fiber for guiding the laser beam and an imaging system including a galvanomirrors for depicting the wiring pattern on the board by scanning the laser beam.

14. The method as claimed in claim 8, wherein the optical system consists of an optical device for preparing a parallel laser beam and an imaging system including galvanomirrors for depicting the wiring pattern on the board by scanning the laser beam.

15. The method as claimed in claim 7, wherein the optical system consists of an optical fiber for guiding the laser beam and an imaging system including a beamsplitting DOE for producing a plurality of beams and irradiate a plurality of spots on the board simultaneously.

16. The method as claimed in claim 8, wherein the optical system consists of an optical device for preparing a parallel laser beam and an imaging system including a beamsplitting DOE for producing a plurality of beams and irradiating a plurality of spots on the board simultaneously.

## Patentansprüche

1. Verfahren zum Ausbilden von Leiterbahnmustern durch Laserbestrahlung, umfassend folgende Schritte:
Vorbereiten eines Metalldispersionskolloides, das über Metallnanopartikel, die Durchmesser von 0,5 nm bis 200 nm haben, ein Dispersionsmittel und ein Lösungsmittel verfügt;
Bestreichen einer Platte mit dem Metalldispersionskolloid;
Trocknen des Metalldispersionskolloids auf der Platte zu einem dünnen Metallsuspensionsfilm;
Aufzeichnen eines Bahnmusters auf dem Metallsuspensionsfilm mit bestrahlenden Laserstrahlen, die eine Wellenlänge zwischen 300 nm und 550 nm haben, durch ein optisches System, wodurch den Metallnanopartikeln eine elektrische Leitfähigkeit und Kohäsion an der Platte in den laserbestrahlten Teilen verliehen wird, die das Bahnmuster haben;
Spülen der Platte zur Beseitigung der anderen Teile des Films, die nicht bestrahlt wurden; und
Erzeugen eines Leiterbahnmusters, das identisch mit einem Muster der Teile ist, die mit den Laserstrahlen bestrahlt werden.

2. Verfahren nach Anspruch 1, bei dem das Dispersionsmittel ein organisches Material ist, das ein Molekulargewicht von mehr als 150 hat und an feinen Metallpartikeln haftet.

3. Verfahren nach Anspruch 1 oder 2, bei dem das Dispersionsmittel makromolekulare Anionen vom Typ der Polycarbonsäure sind.

4. Verfahren nach Anspruch 1, bei dem die Metallnanopartikel Partikel aus Silber (Ag), Gold (Au), Ruthenium (Ru), Rhodium (Rh), Palladium (Pd), Osmium (Os), Iridium (Ir), Platin (Pt), Kupfer (Cu), Nickel (Ni) oder Legierungen aus Silber (Ag), Gold (Au), Ruthenium (Ru), Rhodium (Rh), Palladium (Pd), Osmium (Os), Iridium (Ir), Platin (Pt), Kupfer (Cu) oder Nickel (Ni) bestehen.

5. Verfahren nach einem der Ansprüche 1 bis 4, bei dem die Platte eine Glasplatte, eine keramische Platte, eine Epoxidplatte, eine Polyimidplatte, eine Polyäthylenterephtalat-(PET-) Platte, ein Silizium- (Si-) Wafer, ein Gallium-Arsenid- (GaAs-) Wafer, ein Indiumphosphid- (InP-) Wafer oder ein Siliziumdioxid- (SiO₂-) Wafer ist.

6. Verfahren nach einem der Ansprüche 1 bis 5, bei dem eine Vielzahl von InGaN-Lasern durch einen Faserkoppler zu einer vereinigten Lichtquelle vereinigt sind und der Metallsuspensionsfilm auf der Platte mit dem vereinigten Strahl bestrahlt wird, der von einem Faserende des Kopplers emittiert wird.

7. Verfahren nach einem der Ansprüche 1 bis 5, bei dem das optische System aus einer Lichtleitfaser zum Leiten des Laserstrahls und einem Abbildungssystem besteht, dass das Bahnmuster mit dem Laserstrahl auf die Platte zeichnet.

8. Verfahren nach einem der Ansprüche 1 bis 5, bei dem das optische System aus einer optischen Vorrichtung zum Bereitstellen eines parallelgerichteten Laserstrahls und einem Abbildungssystem besteht, das das Bahnmuster mit dem Laserstrahl auf die Platte zeichnet.

9. Verfahren nach Anspruch 7, bei dem, das optische System eine Lichtleitfaser, die den Laserstrahl leitet, und ein Abbildungssystem hat, das über eine Homogenisiereinrichtung verfügt, die einen Strahl einheitlicher Leistungsverteilung auf der Platte erzeugt.

10. Verfahren nach Anspruch 8, bei dem das optische System aus einer optischen Vorrichtung zum Bereitstellen eines parallelgerichteten Laserstrahls und einem Abbildungssystem besteht, das eine Homogenisiereinrichtung enthält, die einen Strahl einheitlicher Leistungsverteilung auf der Platte erzeugt.

11. Verfahren nach Anspruch 7, bei dem das optische System aus einer Lichtleitfaser zum Leiten des Laserstrahls und einem Abbildungssystem besteht, das eine Strahlformeinrichtung enthält, die einen Strahl beliebiger Leistungsverteilung auf der Platte erzeugt.

12. Verfahren nach Anspruch 8, bei dem das optische System aus einer optischen Vorrichtung zum Bereitstellen eines parallelgerichteten Laserstrahls und einem Abbildungssystem besteht, das eine Strahlformeinrichtung enthält, die einen Strahl beliebiger Leistungsverteilung auf der Platte erzeugt.

13. Verfahren nach Anspruch 7, bei dem das optische System aus einer Lichtleitfaser zum Leiten des Laserstrahls und einem Abbildungssystem besteht, das galvanische Spiegel enthält, um das Bahnmuster auf die Platte durch Überstreichen des Laserstrahls auf die Platte zu zeichnen.

14. Verfahren nach Anspruch 8, bei dem das optische System aus einer optischen Vorrichtung zum Bereitstellen eines parallelgerichteten Laserstrahls und einem Abbildungssystem besteht, das galvanische Spiegel enthält, um das Bahnmuster durch Überstreichen des Lasers auf die Platte zu zeichnen.

15. Verfahren nach Anspruch 7, bei dem das optische System aus einer Lichtleitfaser zum Leiten des Laserstrahls und einem Abbildungssystem besteht, das ein strahlteilendes DOE enthält, um eine Vielzahl von Strahlen zu erzeugen und eine Vielzahl von Punkten gleichzeitig auf die Platte zu strahlen.

16. Verfahren nach Anspruch 8, bei dem das optische System aus einer optischen Vorrichtung zum Bereitstellen eines parallelgerichteten Laserstrahls und einem Abbildungssystem besteht, das ein strahlteilendes DOE enthält, um eine Vielzahl von Strahlen zu erzeugen und eine Vielzahl von Punkten gleichzeitig auf die Platte zu strahlen.

## Revendications

1. Procédé de formation d'un motif de circuit conducteur par irradiation laser comprenant les étapes de :
préparation d'un colloïde de dispersion métallique ayant des nanoparticules métalliques ayant des diamètres de 0,5 nm à 200 nm, un agent de dispersion et un solvant ;
peinture d'une plaquette avec le colloïde de dispersion métallique ;
séchage du colloïde de dispersion métallique sur la plaquette en un film mince de suspension métallique ;
représentation d'un motif de circuit sur le film de suspension métallique avec irradiation avec des faisceaux laser ayant une longueur d'onde entre 300 nm et 500 nm par un système optique, pour donner une conductivité électrique et une cohésion à la plaquette aux nanoparticules métalliques sur les parties irradiées par laser ayant le motif de circuit ;
lavage de la plaquette pour éliminer les autres parties du film qui n'ont pas été irradiées ; et
production d'un motif de circuit conducteur identique à un motif des parties irradiées par les faisceaux laser.

2. Procédé selon la revendication 1, où l'agent de dispersion est une substance organique qui a une masse moléculaire supérieure à 150 et une adhérence aux fines particules métalliques.

3. Procédé selon la revendication 1 ou la revendication 2, où l'agent de dispersion est constitué par des anions macromoléculaires de type poly(acide carboxylique).

4. Procédé selon la revendication 1, où les nanoparticules métalliques sont des particules d'argent (Ag), or (Au), ruthénium (Ru), rhodium (Rh), palladium (Pd), osmium (Os), iridium (Ir), platine (Pt), cuivre (Cu), nickel (Ni) ou d'alliages d'argent (Ag), or (Au), ruthénium (Ru), rhodium (Rh), palladium (Pd), osmium (Os), iridium (Ir), platine (Pt), cuivre (Cu) ou nickel (Ni).

5. Procédé selon l'une quelconque de la revendication 1 à la revendication 4, où la plaquette est une plaquette en verre, une plaquette en céramique, une plaquette en époxyde, une plaquette en polyimide, une plaquette en polyéthylènetéréphtalate (PET), une pastille en silicium (Si), une pastille en arséniure de gallium (GaAs), une pastille en phosphure d'indium (InP) ou une pastille en dioxyde de silicium (SiO₂).

6. Procédé selon l'une quelconque de la revendication 1 à la revendication 5, où une pluralité de lasers à InGaN sont unifiés par un coupleur de fibres en une source lumineuse unifiée, et le film de suspension métallique sur la plaquette est irradié par le faisceau unifié émis depuis une extrémité de fibre du coupleur.

7. Procédé selon l'une quelconque de la revendication 1 à la revendication 5, où le système optique consiste en une fibre optique pour guider le faisceau laser et un système d'imagerie qui représente le motif de circuit par le faisceau laser sur la plaquette.

8. Procédé selon l'une quelconque de la revendication 1 à la revendication 5, où le système optique consiste en un dispositif optique pour préparer un faisceau laser parallèle et un système d'imagerie qui représente le motif de circuit par le faisceau laser sur la plaquette.

9. Procédé selon la revendication 7, où le système optique a une fibre optique guidant le faisceau laser et un système d'imagerie qui inclut un homogénéisateur pour produire un faisceau de distribution d'énergie uniforme sur la plaquette.

10. Procédé selon la revendication 8, où le système optique consiste en un dispositif optique pour préparer un faisceau laser parallèle et un système d'imagerie incluant un homogénéisateur pour produire un faisceau de distribution d'énergie uniforme sur la plaquette.

11. Procédé selon la revendication 7, où le système optique consiste en une fibre optique pour guider le faisceau laser et un système d'imagerie incluant un modeleur de faisceau pour produire un faisceau de distribution d'énergie arbitraire sur la plaquette.

12. Procédé selon la revendication 8, où le système optique consiste en un dispositif optique pour préparer un faisceau laser parallèle et un système d'imagerie incluant un modeleur de faisceau pour produire un faisceau de distribution d'énergie arbitraire sur la plaquette.

13. Procédé selon la revendication 7, où le système optique consiste en une fibre optique pour guider le faisceau laser et un système d'imagerie incluant des galvanomiroirs pour représenter le motif de circuit sur la plaquette par balayage avec le faisceau laser.

14. Procédé selon la revendication 8, où le système optique consiste en un dispositif optique pour préparer un faisceau laser parallèle et un système d'imagerie incluant des galvanomiroirs pour représenter le motif de circuit sur la plaquette par balayage avec le faisceau laser.

15. Procédé selon la revendication 7, où le système optique consiste en une fibre optique pour guider le faisceau laser et un système d'imagerie incluant un DOE diviseur de faisceau pour produire une pluralité de faisceaux et irradier une pluralité de points sur la plaquette simultanément.

16. Procédé selon la revendication 8, où le système optique consiste en un dispositif optique pour préparer un faisceau laser parallèle et un système d'imagerie incluant un DOE diviseur de faisceau pour produire une pluralité de faisceaux et irradier une pluralité de points sur la plaquette simultanément.
